# EUROPEAN PATENT APPLICATION

(11) **EP 4 451 337 A1**
(43) Date of publication of application: **23.10.2024**
(21) Application number: 22954529.8
(22) Date of filing: 11.08.2022
(51) Int. Cl.: H01L 27/15, H01L 33/62, G09F 9/33

(54) **DISPLAY PANEL, DISPLAY DEVICE AND TILED DISPLAY DEVICE**

(71) Applicant: Boe Technology Group Co., Ltd., Beijing 100015 (CN); BOE MLED Technology Co., Ltd., Beijing 100176 (CN)
(72) Inventor: WANG, Lili, Beijing 100176 (CN); CAI, Ting, Beijing 100176 (CN); LIU, Chao, Beijing 100176 (CN); ZHAI, Ming, Beijing 100176 (CN); SUN, Haiwei, Beijing 100176 (CN); QI, Qi, Beijing 100176 (CN)
(74) Representative: Hoffmann Eitle
(86) International application number: PCT/CN2022/111878
(87) International publication number: WO 2024/031563

(57) **Abstract**

A display panel (10), comprising: a substrate (1), a plurality of first bonding electrodes (2), a plurality of connecting leads (3), an electrode carrier plate (4), and a plurality of second bonding electrodes (5). The substrate (1) comprises a display face (1a) and a non-display face (1b) opposite to each other, and a plurality of side faces (1c), wherein at least one side face (1c) is a selected side face (1cc). The display face (1a) comprises a first bonding area (BB1), the non-display face (1b) comprises a second bonding area (BB2), and the first bonding area (BB1) and the second bonding area (BB2) are both close to the selected side face (1cc) and are arranged opposite each other. The plurality of first bonding electrodes (2) are arranged side by side at intervals in the first bonding area (BB1). The plurality of connecting leads (3) are arranged side by side at intervals, each connecting lead (3) comprises a first part (31) located in the first bonding area (BB1), a second part (32) located on one side of the selected side face (1cc), and a third part (33) located in the second bonding area (BB2), and a first part (31) of each connecting lead (3) is electrically connected to a first bonding electrode (2). The electrode carrier plate (4) is arranged on one side of the non-display face (1b), a plurality of second bonding electrodes (5) arranged side by side at intervals are arranged on the side of the electrode carrier plate (4) away from the substrate (1), and each second bonding electrode (5) is electrically connected to a third part (33) of a connecting lead (3).

## Description

### TECHNICAL FIELD

The present disclosure relates to the field of display technologies, and in particular, to a display panel, a display device and a tiled display device.

### BACKGROUND

Compared with traditional light-emitting diodes (LEDs), micro light-emitting diodes (micro LEDs) and mini light-emitting diodes (mini LEDs) have smaller particles, that is, smaller size.

### SUMMARY

In an aspect, a display panel is provided. The display panel includes a substrate, a plurality of first bonding electrodes, a plurality of connecting leads, an electrode carrier plate and a plurality of second bonding electrodes. The substrate includes a display surface and a non-display surface that are opposite, and a plurality of side faces connected to the display surface and the non-display surface, wherein at least one side face is a selected side face. The display surface includes a first bonding area, the non-display surface includes a second bonding area, and the first bonding area and the second bonding area are both proximate to the selected side face and disposed oppositely. The plurality of first bonding electrodes are disposed side by side and at intervals in the first bonding area. The plurality of connecting leads are disposed side by side and at intervals. Each connecting lead includes a first portion located in the first bonding area, a second portion located on the selected side face and a third portion located in the second bonding area, and the first portion of each connecting lead is electrically connected to a first bonding electrode. The electrode carrier plate is disposed on the non-display surface, and the plurality of second bonding electrodes are provided on a surface of the electrode carrier plate away from the substrate. The plurality of second bonding electrodes are arranged side by side and at intervals, and each second bonding electrode is electrically connected to a third portion of a connecting lead.

In some embodiments, the display panel further includes a plurality of connection pads arranged side by side and at intervals. The plurality of connection pads are located on a side of the plurality of second bonding electrodes away from the substrate, and each connection pad is connected to a second bonding electrode and a third portion of a connecting lead.

In some embodiments, the connection pad includes metal or conductive adhesive.

In some embodiments, a shape of an orthographic projection of the connection pad on the substrate includes a circle, an ellipse, a triangle, a star, a square, a heart or a trapezoid.

In some embodiments, the electrode carrier plate is provided therein with a plurality of connecting via holes arranged side by side and at intervals. Each second bonding electrode includes a first bonding end and a second bonding end. The first bonding end of the second bonding electrode is located on a side of the electrode carrier plate away from the substrate, and the second bonding end of the second bonding electrode passes through a connecting via hole to be electrically connected to the third portion of the connecting lead.

In some embodiments, the second bonding end of the second bonding electrode is located on a side of the third portion of the connecting lead connected to the second bonding end away from the substrate. The display panel further includes a binder disposed in the connecting via hole and configured to connect the second bonding end and the third portion of the connecting lead.

In some embodiments, the display panel further includes an adhesive disposed on a side of the second bonding end of the second bonding electrode away from the selected side face. A surface of the adhesive is bonded to a surface of the electrode carrier plate proximate to the substrate, and another surface of the adhesive faces the substrate. The adhesive is configured to bond the electrode carrier plate and the substrate.

The second bonding end of the second bonding electrode is located on a side of the third portion of the connecting lead connected to the second bonding end away from the substrate, and the adhesive is located between the electrode carrier plate and the substrate. In a direction perpendicular to the electrode carrier plate, a dimension of the adhesive is same as a dimension of the third portion of the connecting lead.

In some embodiments, the adhesive is an insulating adhesive.

In some embodiments, the plurality of connecting leads are arranged side by side and at intervals in a first direction, and the plurality of second bonding electrodes are arranged side by side and at intervals in the first direction. The display panel further includes a conductive adhesive disposed on a side of the plurality of connecting leads away from the non-display surface of the substrate and configured to connect the second bonding electrode and the connecting lead. The conductive adhesive extending in the first direction. The conductive adhesive covers at least portions of the connecting leads connected to the plurality of second bonding electrodes.

In some embodiments, a material of the electrode carrier plate includes an insulated material.

In some embodiments, the material of the electrode carrier plate includes glass or a polyimide film.

In some embodiments, a material of the first bonding electrodes includes metal, and materials of the connecting leads and the second bonding electrodes include metal or conductive metal colloid.

In some embodiments, the material of the first bonding electrodes includes at least one of copper, titanium, aluminum, molybdenum or nickel alloy.

In some embodiments, the materials of the connecting leads and the second bonding electrodes include at least one of copper, titanium, aluminum, molybdenum, nickel alloy, or conductive silver adhesive.

In some embodiments, the second bonding area extends in a first direction, the third portion of each connecting lead extends in a second direction, and the first direction intersects the second direction. A dimension of a connection pad in the first direction is greater than one third of a dimension of a third portion of a connecting lead connected to the connection pad in the first direction.

In some embodiments, a sum of a dimension of the third portion of the connecting lead connected to the second bonding electrode in the first direction and a distance between third portions of two adjacent connecting leads in the first direction is greater than the dimension of the connection pad in the first direction.

In some embodiments, a dimension of a connection pad in a direction perpendicular to the selected side face is less than or equal to a distance between an edge of an orthographic projection of the second bonding electrode connected to the connection pad on the substrate away from the selected side face and the selected side face.

In some embodiments, the display panel further includes a flexible circuit board disposed on a side of the plurality of second bonding electrodes away from the substrate. Each second bonding electrode extends in a second direction. Each second bonding electrode includes a first bonding end and a second bonding end, the first bonding end is configured to be electrically connected to the flexible circuit board, and the second bonding end is configured to be electrically connected to the third portion of the connecting lead.

In some embodiments, portions of a second bonding end and the third portion of the connecting lead that are connected have an overlap. A sum of a dimension of the third portion of the connecting lead in a direction perpendicular to the selected side face and a dimension of the second bonding electrode in the direction perpendicular to the selected side face is equal to a sum of a distance between an edge of an orthographic projection of the second bonding electrode on the substrate away from the selected side face and the selected side face and a dimension of a portion of the second bonding end overlapped with the third portion of the connecting lead in the direction perpendicular to the selected side face.

In some embodiments, a dimension of the third portion of the connecting lead in a direction perpendicular to the selected side face is less than or equal to a distance between an edge of an orthographic projection of the first electrode on the substrate away from the selected side face and the selected side face.

In some embodiments, a dimension of the first portion of the connecting lead connected to the first bonding electrode in a direction perpendicular to an extending direction of the first portion of the connecting lead is greater than or equal to thirty percent of a dimension of the first bonding electrode in a direction perpendicular to an extending direction of the first bonding electrode.

In some embodiments, a difference between a sum of the dimension of the first bonding electrode in the direction perpendicular to the extending direction of the first bonding electrode and a distance between two adjacent first bonding electrodes in the direction perpendicular to the extending direction of the first bonding electrodes and a distance between first portions of two adjacent connecting leads in a direction perpendicular to an extending direction of the first portions of the two connecting leads is greater than or equal to the dimension of the first portion of the connecting lead connected to the first bonding electrode in the direction perpendicular to the extending direction of the first portion of the connecting lead.

In another aspect, a display device is provided. The display device includes the display panel as described in any of the above embodiments.

In yet another aspect, a tiled display device is provided. The tiled display device includes the display device as described in any of the above embodiments.

In yet another aspect, a method for manufacturing a display panel is provided. The method includes following steps.

A substrate is provided. The substrate includes a display surface and a non-display surface that are opposite, and a plurality of side faces connected to the display surface and the non-display surface. At least one side face in the plurality of side faces is a selected side face. The display surface includes a first bonding area, the non-display surface includes a second bonding area, and the first bonding area and the second bonding area are both proximate to the selected side face and disposed oppositely.

A plurality of first bonding electrodes arranged side by side and at intervals are formed on the display surface of the substrate. The plurality of first bonding electrodes are disposed in the first bonding area.

A plurality of connecting leads arranged side by side and at intervals are formed. Each connecting lead includes a first portion located in the first bonding area, a second portion located on the selected side face and a third portion located in the second bonding area. The first portion of each connecting lead is electrically connected to a first bonding electrode.

An electrode carrier plate is provided, and a plurality of second bonding electrodes arranged side by side and at intervals are formed on the electrode carrier plate.

The electrode carrier plate provided with the plurality of second bonding electrodes thereon is provided on a side of the non-display surface of the substrate, and each second bonding electrode is connected to a third portion of a connecting lead.

### BRIEF DESCRIPTION OF THE DRAWINGS

In order to describe technical solutions in the present disclosure more clearly, accompanying drawings to be used in some embodiments of the present disclosure will be introduced briefly below. Obviously, the accompanying drawings to be described below are merely accompanying drawings of some embodiments of the present disclosure, and a person of ordinary skill in the art may obtain other drawings according to these drawings. In addition, the accompanying drawings to be described below may be regarded as schematic diagrams, but are not limitations on an actual size of a product, an actual process of a method and an actual timing of a signal to which the embodiments of the present disclosure relate.
FIG. 1 is a sectional view of a display panel, in accordance with some embodiments;
FIG. 2 is a diagram showing a front structure of a display panel, in accordance with some embodiments;
FIG. 3 is a diagram showing a front structure of another display panel, in accordance with some embodiments;
FIG. 4 is a diagram showing a back structure of a display panel, in accordance with some embodiments;
FIG. 5 is a diagram showing a back structure of another display panel, in accordance with some embodiments;
FIG. 6 is a sectional view of a display panel, in accordance with some embodiments;
FIG. 7 is an enlarged view of a back of an area C of the display panel shown in FIG. 3;
FIG. 8 is an enlarged view of a front of an area C of the display panel shown in FIG. 3;
FIG. 9 is a sectional view of another display panel, in accordance with some embodiments;
FIG. 10 is a structural diagram of both an electrode carrier plate and a second bonding electrode in the display panel shown in FIG. 9;
FIG. 11 is a structural diagram of both another electrode carrier plate and another second bonding electrode in the display panel shown in FIG. 9;
FIG. 12 is a structural diagram of an adhesive in the display panel shown in FIG. 9;
FIG. 13 is a structural diagram of another adhesive in the display panel shown in FIG. 9;
FIG. 14 is a structural diagram of another adhesive in the display panel shown in FIG. 9;
FIG. 15 is a sectional view of yet another display panel, in accordance with some embodiments;
FIG. 16 is a structural diagram of both an electrode carrier plate and a second bonding electrode in the display panel shown in FIG. 15;
FIG. 17 is a structural diagram of both another electrode carrier plate and another second bonding electrode in the display panel shown in FIG. 15;
FIG. 18 is a structural diagram of an adhesive in the display panel shown in FIG. 15;
FIG. 19 is a structural diagram of another adhesive in the display panel shown in FIG. 15;
FIG. 20 is a structural diagram of another adhesive in the display panel shown in FIG. 15;
FIG. 21 is a sectional view of yet another display panel, in accordance with some embodiments;
FIG. 22 is a diagram showing a front structure of a display device, in accordance with some embodiments;
FIG. 23 is a structural diagram of a tiled display device, in accordance with some embodiments;
FIG. 24 is a structural diagram of another tiled display device, in accordance with some embodiments; and
FIG. 25 is a flow diagram of a method for manufacturing a display panel, in accordance with some embodiments.

### DETAILED DESCRIPTION

Technical solutions in some embodiments of the present disclosure will be described clearly and completely with reference to the accompanying drawings below. Obviously, the described embodiments are merely some but not all embodiments of the present disclosure. All other embodiments obtained by a person of ordinary skill in the art based on the embodiments of the present disclosure shall be included in the protection scope of the present disclosure.

Unless the context requires otherwise, throughout the description and the claims, the term "comprise" and other forms thereof such as the third-person singular form "comprises" and the present participle form "comprising" are construed as open and inclusive, i.e., "including, but not limited to". In the description of the specification, the terms such as "one embodiment", "some embodiments", "exemplary embodiments", "example", "specific example" or "some examples" are intended to indicate that specific materials, or characteristics described herein may be included in any one or more embodiments or examples in any suitable manner.

Hereinafter, the terms such as "first" and "second" are used for descriptive purposes only, and are not to be construed as indicating or implying the relative importance or implicitly indicating the number of indicated technical features. Thus, features defined with "first" or "second" may explicitly or implicitly include one or more of the features. In the description of the embodiments of the present disclosure, the term "a plurality of" or "the plurality of" means two or more unless otherwise specified.

In the description of some embodiments, the expressions "coupled," "connected," and derivatives thereof may be used. For example, the term "connected" may be used in the description of some embodiments to indicate that two or more elements are in direct physical or electrical contact with each other. For another example, the term "coupled" may be used in the description of some embodiments to indicate that two or more elements are in direct physical or electrical contact. However, the term "coupled" or "communicatively coupled" may also mean that two or more elements are not in direct contact with each other, but still cooperate or interact with each other. The embodiments disclosed herein are not necessarily limited to the content herein.

The phrase "at least one of A, B and C" has a same meaning as the phrase "at least one of A, B or C", and they both include the following combinations of A, B and C: only A, only B, only C, a combination of A and B, a combination of A and C, a combination of B and C, and a combination of A, B and C.

The phrase "A and/or B" includes the following three combinations: only A, only B, and a combination of A and B.

The phrase "applicable to" or "configured to" as used herein indicates an open and inclusive expression, which does not exclude apparatuses that are applicable to or configured to perform additional tasks or steps.

The term "about," "substantially," and "approximately" as used herein includes a stated value and an average value within an acceptable range of deviation of a particular value determined by a person of ordinary skill in the art, considering measurement in question and errors associated with measurement of a particular quantity (i.e., limitations of a measurement system).

The term such as "parallel", "perpendicular" or "equal" as used herein includes a stated condition and a condition similar to the stated condition. A range of the similar condition is within an acceptable range of deviation. The acceptable range of deviation is determined by a person of ordinary skill in the art in view of measurement in question and errors associated with the measurement of a particular quantity (i.e., limitations of the measurement system). For example, the term "parallel" includes absolute parallelism and approximate parallelism, and an acceptable range of deviation of the approximate parallelism may be a deviation within 5°; the term "perpendicular" includes absolute perpendicularity and approximate perpendicularity, and an acceptable range of deviation of the approximate perpendicularity may also be a deviation within 5°; and the term "equal" includes absolute equality and approximate equality, and an acceptable range of deviation of the approximate equality may be a difference between two equals being less than or equal to 5% of either of the two equals.

It will be understood that when a layer or element is referred to as being on another layer or substrate, the layer or element may be directly on the another layer or substrate, or there may be intermediate layer(s) between the layer or element and the another layer or substrate.

Exemplary embodiments are described herein with reference to sectional views and/or plan views as idealized exemplary drawings. In the accompanying drawings, thicknesses of layers and sizes of areas are enlarged for clarity. Variations in shapes relative to the accompanying drawings due to, for example, manufacturing technologies and/or tolerances may be envisaged. Therefore, the exemplary embodiments should not be construed to be limited to the shapes of areas shown herein, but to include deviations in the shapes due to, for example, manufacturing. For example, an etched area shown in a rectangular shape generally has a feature of being curved. Therefore, the areas shown in the accompanying drawings are schematic in nature, and their shapes are not intended to show actual shapes of the areas in an apparatus, and are not intended to limit the scope of the exemplary embodiments.

In order to improve product reliability and reduce transportation and maintenance costs, large-sized display devices may be assembled by tiling a plurality of small-sized display devices.

In order to avoid fragmentation of a display picture caused by tiling, it is necessary to reduce a frame size of a small-sized display device and reduce a width of a tiling seam. The small-sized display device includes a display panel. For example, the wiring on a display surface of the display panel and a circuit board (e.g., a flexible circuit board) provided on a side of a non-display surface of the display panel may be connected by the wiring on the side face, and thus in a case where the plurality of small-sized display devices are tiled to form a large-sized display device, adjacent small-sized display devices may have small spacing therebetween. As a result, the display quality of the large-sized display device formed by tiling the plurality of small-sized display devices may be improved.

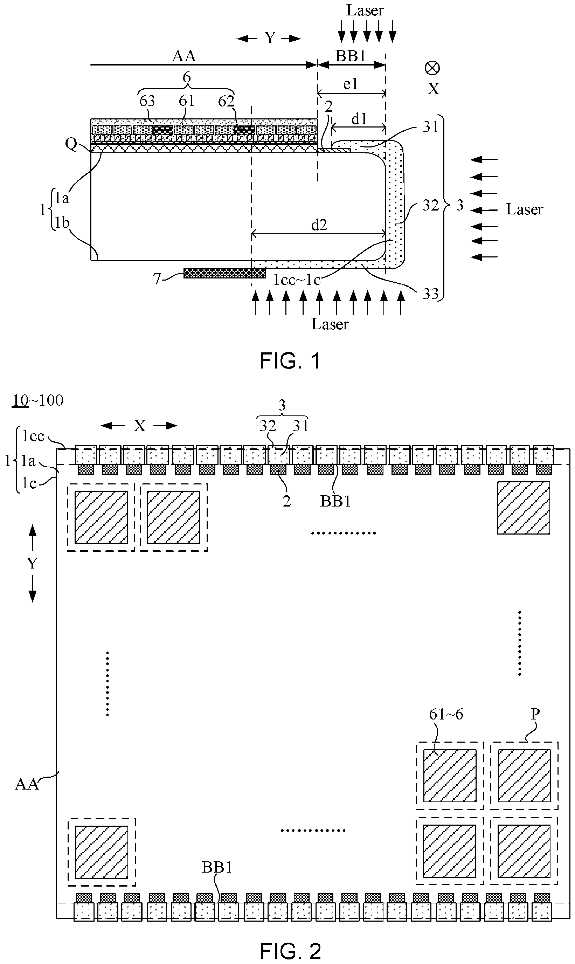

As shown in FIG. 1, in some embodiments, the display panel 10 includes a substrate 1, a plurality of first bonding electrodes 2 and a plurality of connecting leads 3. The substrate 1 includes a display surface 1a and a non-display surface 1b that are opposite, and a plurality of side faces 1c connected to the display surface 1a and the non-display surface 1b. At least one side face 1c in the plurality of side faces 1c of the substrate 1 is a selected side face 1cc. Each connecting lead 3 includes a first portion 31 located on the display surface 1a of the substrate 1, a second portion 32 located on the selected side face 1cc of the substrate 1, and a third portion 33 located on the non-display surface 1b of the substrate 1.

A side of the display surface 1a of the substrate 1 is a front surface of the display panel, and a side of the non-display surface 1b of the substrate 1 is a back surface of the display panel. The display surface 1a of the substrate 1 includes a display area AA. The display area AA is provided thereon with a driving circuit layer Q, a light-emitting device layer 6, and other film layer structures. The first portions 31 of the plurality of connecting leads 3 are located on the display surface 1a of the substrate 1, and the third portions 33 of the plurality of connecting leads 3 are located on the non-display surface 1b of the substrate 1. Both the first portions 31 and the third portions 33 of the connecting leads 3 extend in a direction perpendicular to the selected side face 1cc of the substrate 1, for example, a Y direction shown in FIG. 1.

The third portions 33 of the plurality of connecting leads 3 are configured to be connected to the circuit board located on a side of the non-display surface 1b of the substrate 1. For example, ends of the third portions 33 of the plurality of connecting leads 3 away from the selected side face 1cc are used as bonding electrodes for being connected to the flexible circuit board 7, that is, the wiring on the back surface of the display panel need to reserve a large space for external circuit bonding. Therefore, in a direction perpendicular to the selected side face 1cc, a length of the third portion 33 of the connecting lead 3 is greater than a length of the first portion 31 of the connecting lead. That is, the length d1 of the first portion 31 of each of the plurality of connecting leads 3 located on the display surface 1a of the substrate 1 is less than the length d2 of the third portion 33 of each of the plurality of connecting leads located on the non-display surface 1b of the substrate 1. It can be understood that an orthographic projection of the third portion 33 of the connecting lead 3 on the substrate 1 has overlap with an area corresponding to the display area AA.

For the length of the third portion 33 of each of the plurality of connecting leads 3 located on the non-display surface 1b of the substrate 1, there are several cases as follows.

In some embodiments, the plurality of connecting leads 3 are arranged side by side and at intervals in a first direction X, the second direction Y intersects the first direction X. The third portion 33 of the connecting lead 3 is in a linear shape, and the third portion 33 of the connecting lead 3 extends in the Y direction. Therefore, the length d2 of the third portion 33 of the connecting lead 3 is a length of the third portion 33 of the connecting lead 3 in the second direction Y.

In some other embodiments, the plurality of connecting leads 3 are arranged side by side and at intervals in a first direction X, the second direction Y intersects the first direction X. The third portion 33 of the connecting lead 3 is in a non-linear shape. The third portion 33 of the connecting lead 3 includes a plurality of portions with different extending directions that are connected in sequence. The third portion 33 of each connecting lead 3 includes a plurality of sub-portions with different extending directions. For example, the third portion 33 of each connecting lead 3 includes a first sub-portion, a second sub-portion and a third sub-portion, and the first sub-portion, the second sub-portion and the third sub-portion included in the third portion 33 of the connecting lead 3 have different extension directions. An included angle between each of the plurality of sub-portions included in the connecting lead 3 and the second direction Y is not greater than 60°. A whole of the third portion 33 of the connecting lead 3 may be considered to extend substantially in the Y direction. Thus, the length d2 of the third portion 33 of the connecting lead 3 in the non-linear shape is a sum of lengths of orthogonal projections of the plurality of sub-portions included in the third portion 33 of the connecting lead 3 on the substrate 1 in the second direction Y.

In some examples, the process of forming the plurality of connecting leads 3 is as follows: forming an entire connecting metal layer on at least one side face 1c of the substrate 1, for example, forming a connecting metal layer through a three-dimensional sputtering coating process, specifically, the connecting metal layer being located on the display surface 1a of the substrate 1, the side face 1c of the substrate 1 and the non-display surface 1b of the substrate 1; then, patterning the connecting metal layer by laser etching to form a plurality of independent connecting leads 3.

It can be understood that each connecting lead 3 includes a first portion 31 located on the display surface 1a of the substrate 1, a third portion 33 located on the selected side face 1cc of the substrate 1, and a third portion 33 located on the non-display surface 1b of the substrate 1, and the length of the first portion 31 of the connecting lead 3 is less than the length of the third portion 33 of the connecting lead 3. Therefore, an area of the connecting metal layer located on the display surface 1a of the substrate 1 is smaller than an area of the connecting metal layer located on the non-display surface 1b of the substrate 1. In this way, during actual laser etching, the non-display surface 1b of the substrate 1 has a longer line that needs to be laser etched. In a process of etching to obtain the third portion 33 of the connecting lead 3, the laser may pass through the substrate 1 to be incident on the display area AA of the display surface 1a. Referring to FIG. 1, laser is irradiated to the substrate 1 in directions of Laser shown in the figure. Since the orthographic projection of the third portion 33 of the connecting lead 3 on the substrate 1 has overlap with an area corresponding to the display area AA, a part of energy of the laser will pass through the substrate 1 to reach the display area AA and cause damage to the film layers and devices within the area, resulting in reliability problems such as local corrosion and the failure of the light-emitting device to light up.

In some embodiments, the driving circuit layer Q may include thin film transistors. When the third portion 33 of the connecting lead 3 is etched using laser, after an active layer of the thin film transistor in the driving circuit layer Q at the front is irradiated by the laser, characteristics of the thin film transistor may be caused to change, for example, the threshold current for turning off the thin film transistor increases, thereby affecting the display effect. The above manufacturing processes, such as the sputtering coating process and the laser etching process, are only described as an example, and are not intended to limit the actual manufacturing process.

The display panel, the display device and the tiled display device provided by the present disclosure are introduced below.

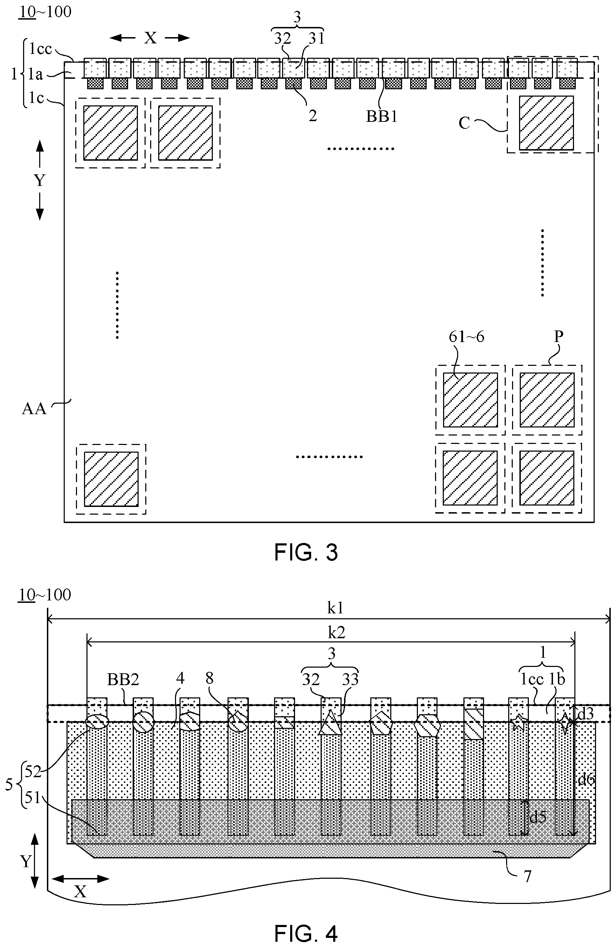

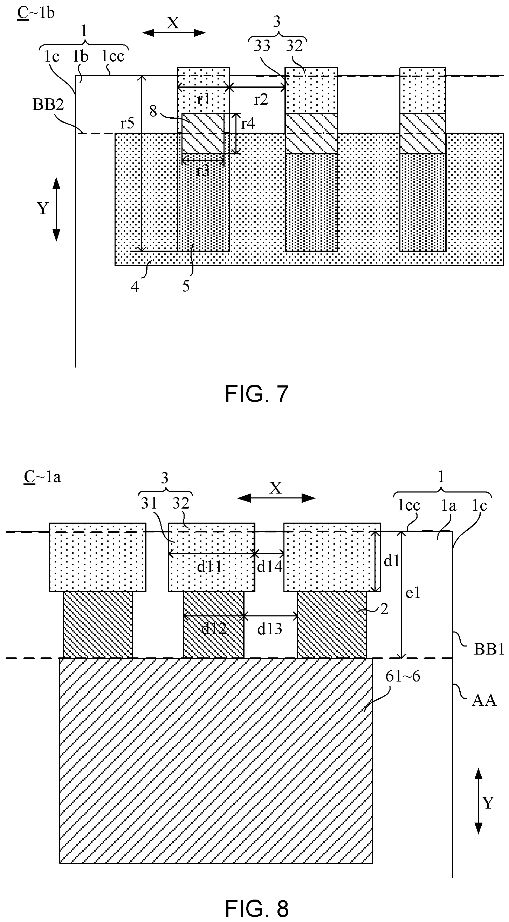

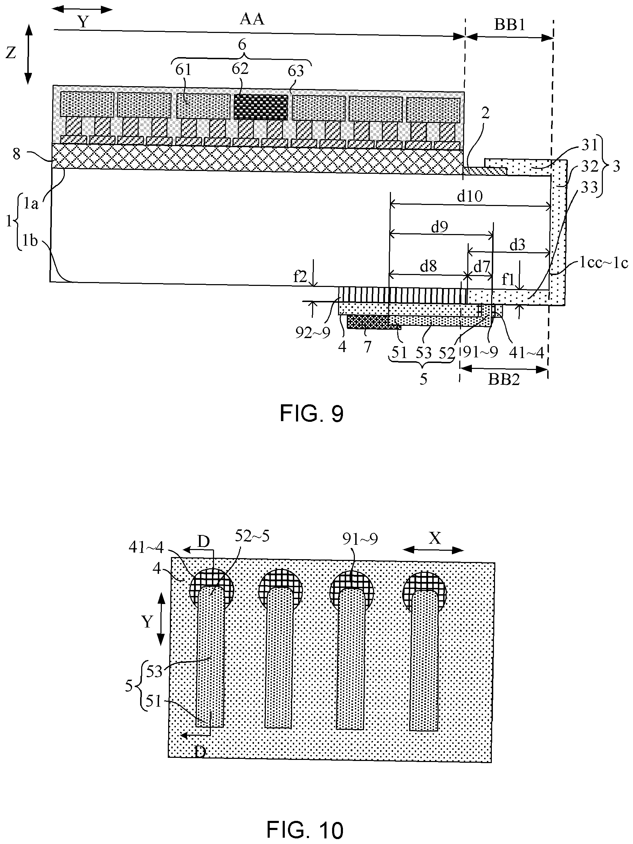

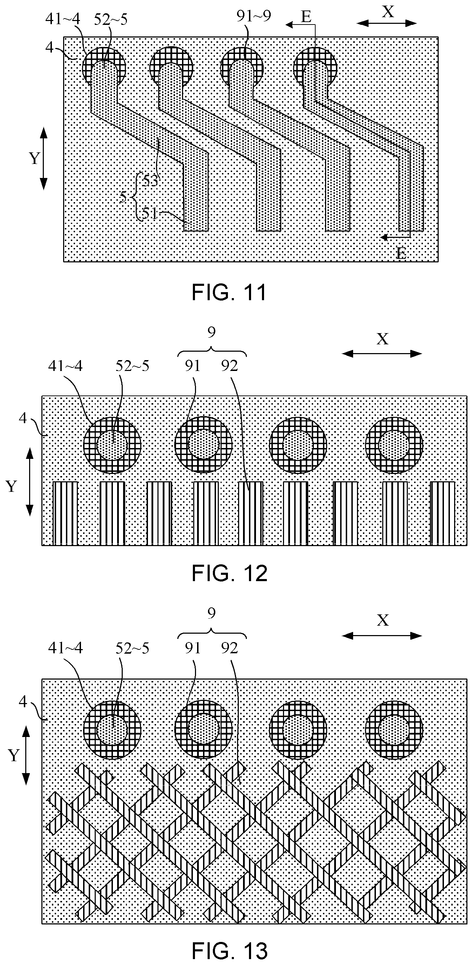

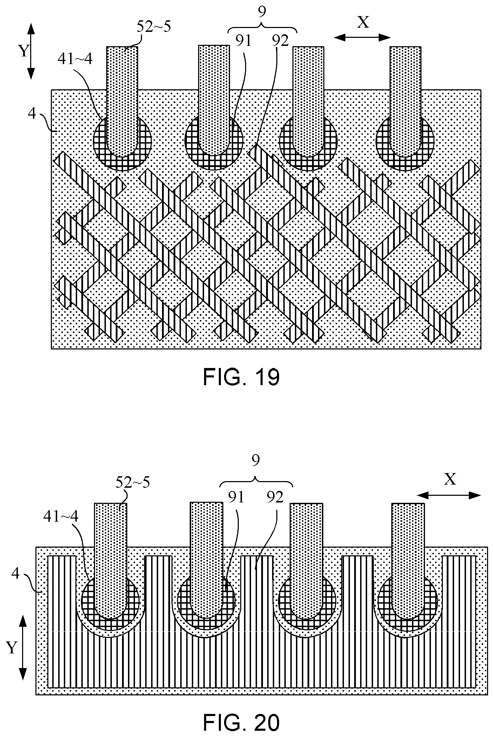

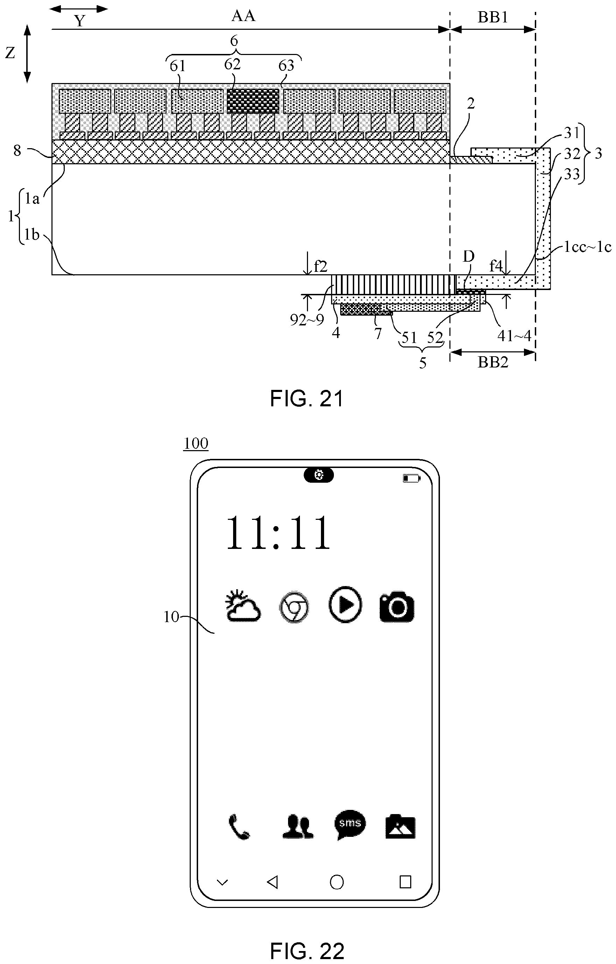

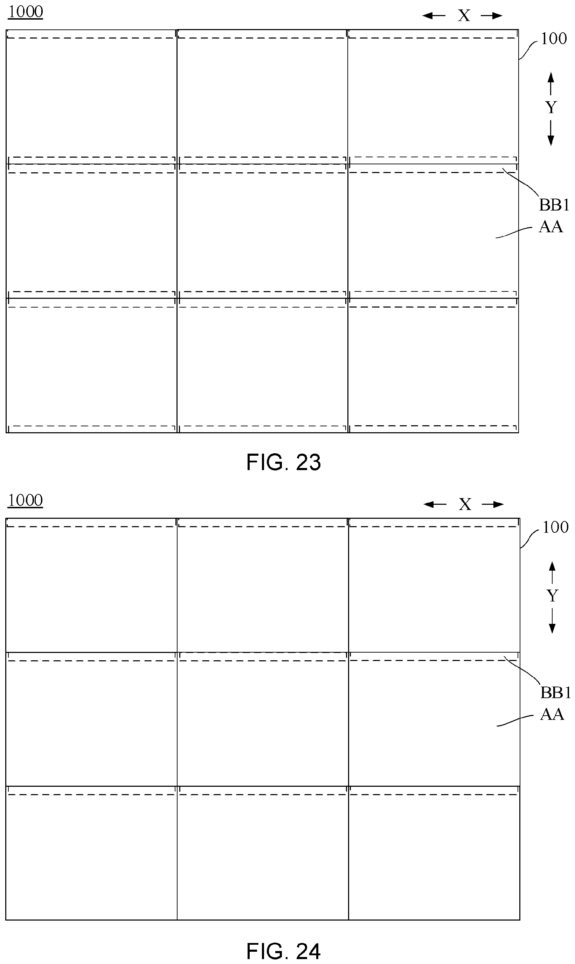

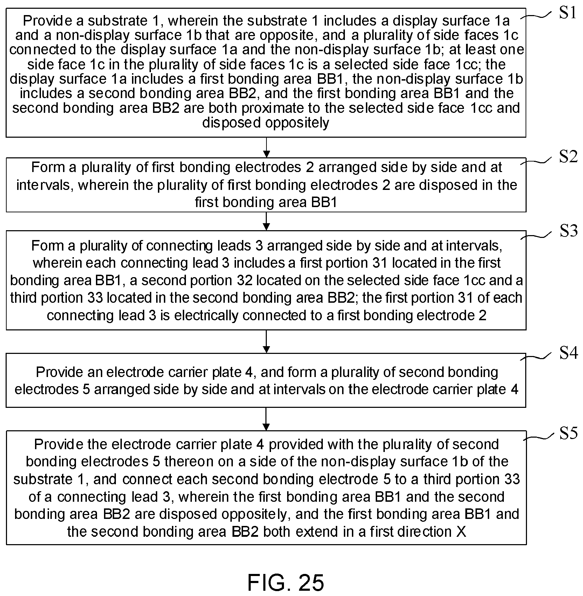

In the present disclosure, FIGS. 2, 3, 4 and 5 are each a plan view showing a structure of the display panel 10. FIG. 7 is an enlarged view of a back of an area C of the display panel 10 shown in FIG. 3. FIG. 8 is an enlarged view of a front of an area C of the display panel 10 shown in FIG. 3. FIGS. 10, 11, 16 and 17 are each a structural diagram of a surface of an electrode carrier plate 4 away from the substrate 1 in accordance to some embodiments. FIGS. 12, 13, 14, 18, 19 and 20 are each a structural diagram of a surface of an electrode carrier plate 4 proximate to the substrate 1 in accordance to some embodiments. FIG. 22 is a diagram showing a front structure of the display device 100 in accordance with some embodiments. FIGS. 23 and 24 are each a structural diagram of the tiled display device in accordance with some embodiments. FIG. 25 is a flow diagram of a method for manufacturing a display panel in accordance with some embodiments.

Hereinafter, a side of the display surface 1a of the display panel 10 is referred to as the front surface of the display panel 10, and correspondingly, a side of the non-display surface 1b of the display panel 10 is referred to as the back surface of the display panel 10.

Some embodiments of the present disclosure provide a display panel 10. As shown in FIGS. 2, 3, 4 and 5, the display panel 10 includes a substrate 1, a plurality of first bonding terminals 2, a plurality of connecting leads 3, electrode carrier plate(s) 4 and a plurality of second bonding electrodes 5. The electrode carrier plate 4 is disposed on the non-display surface 1b of the substrate 1, and the plurality of second bonding electrodes 5 are disposed on a side of the electrode carrier plate(s) 4 away from the substrate 1.

The substrate 1 includes a display surface 1a and a non-display surface 1b that are opposite, and a plurality of side faces 1c connected to the display surface 1a and the non-display surface 1b. At least one side face 1c is a selected side face 1cc. The display surface 1a of the substrate 1 includes first bonding area(s) BB1, and the non-display surface 1b of the substrate 1 includes second bonding area(s) BB2. The first bonding area BB1 and the second bonding area BB2 are both proximate to the selected side face 1cc of the substrate 1 and are disposed oppositely. The description of disposed oppositely here means that an area corresponding to the second bonding area BB2 on the display surface 1a of the substrate 1 overlaps or substantially overlaps with an area corresponding to the first bonding area BB1.

A plurality of first bonding electrodes 2 are provided in the first bonding area BB1, and the plurality of first bonding electrodes 2 are arranged side by side and at intervals. Edges of the plurality of first bonding electrodes 2 away from the selected side face 1cc of the substrate 1 are flush or substantially flush.

A plurality of second bonding electrodes 5 are provided on a side of the electrode carrier plate 4 away from the substrate 1, and the plurality of second bonding electrodes 5 are arranged side by side and at intervals. Edges of the plurality of second bonding electrodes 5 away from the selected side face 1cc of the substrate 1 are flush or substantially flush.

A plurality of connecting leads 3 are arranged side by side and at intervals. Each connecting lead 3 includes a first portion 31 located in the first bonding area BB1, a second portion 32 located on the selected side face 1cc, and a third portion 33 located in the second bonding area BB2. The first portion 31 of each connecting lead 3 is electrically connected to a first bonding electrode 2, and the third portion 33 of each connecting lead 3 is electrically connected to a second bonding electrode 5.

In some embodiments, as shown in FIGS. 3, 4 and 5, the first bonding area BB1 and the second bonding area BB2 both extend in the first direction X. The plurality of first bonding electrodes 2 are arranged side by side and at intervals in the first direction X, and each first bonding electrode 2 extends in the second direction Y The plurality of second bonding electrodes 5 are arranged side by side and at intervals in the first direction X, and each second bonding electrode 5 extends in the second direction Y The first direction X intersects the second direction Y

For example, the second direction Y is perpendicular to the first direction X.

For example, as shown in FIGS. 2 and 3, the display surface 1a of the substrate 1 includes a display area AA, and the first bonding area(s) BB1 are located at least on a side of the display area AA.

In some embodiments, as shown in FIG. 2, the substrate 1 includes two first bonding areas BB1 provided oppositely, and the first bonding areas BB1 are located on opposite sides of the display area AA.

In some other embodiments, as shown in FIG. 3, the substrate 1 includes a single first bonding area BB1, and the first bonding area BB1 is located on a side of the display area AA.

The driving circuit layer Q is disposed on the display surface 1a of the substrate 1 and is located in the display area AA. The light-emitting device layer 6 is disposed on a side of the driving circuit layer Q away from the substrate 1. The light-emitting device layer 6 includes a plurality of light-emitting devices 61. The driving circuit layer Q includes signal lines. The signal lines are connected to the light-emitting devices 61, and are configured to transmit signals to the light-emitting devices 61, so as to drive the plurality of light-emitting devices 61 in the light-emitting device layer 6 to emit light.

The above-mentioned the front film layer(s) of the display panel damaged by laser include the driving circuit layer Q, the light-emitting device layer 6, and the like.

For example, the second bonding electrode 5 includes a first bonding end 51 and a second bonding end 52. The first bonding end 51 of the second bonding electrode 5 is configured to be electrically connected to the flexible circuit board 7. The second bonding end 52 of the second bonding electrode 5 is configured to be electrically connected to the third portion 33 of the connecting lead 3.

For the plurality of second bonding electrodes 5, there are several cases as follows.

In some embodiments, as shown in FIG. 4, the second bonding electrode 5 is in a linear shape. A plurality of second bonding electrodes 5 are arranged side by side and spaced apart in the first direction X. The second bonding electrodes 5 extend in a direction perpendicular to the selected side face 1cc of the substrate 1. For example, the second bonding electrode 5 extends in the second direction Y shown in FIG. 4, and a length d6 of the second bonding electrode 5 is a length of the second bonding electrode 5 in the second direction Y

For example, as shown in FIG. 4, a dimension k1 of the selected side face 1cc of the substrate 1 in the first direction X is greater than a dimension k2 of an area covered by the plurality of second bonding electrodes 5 in the first direction X.

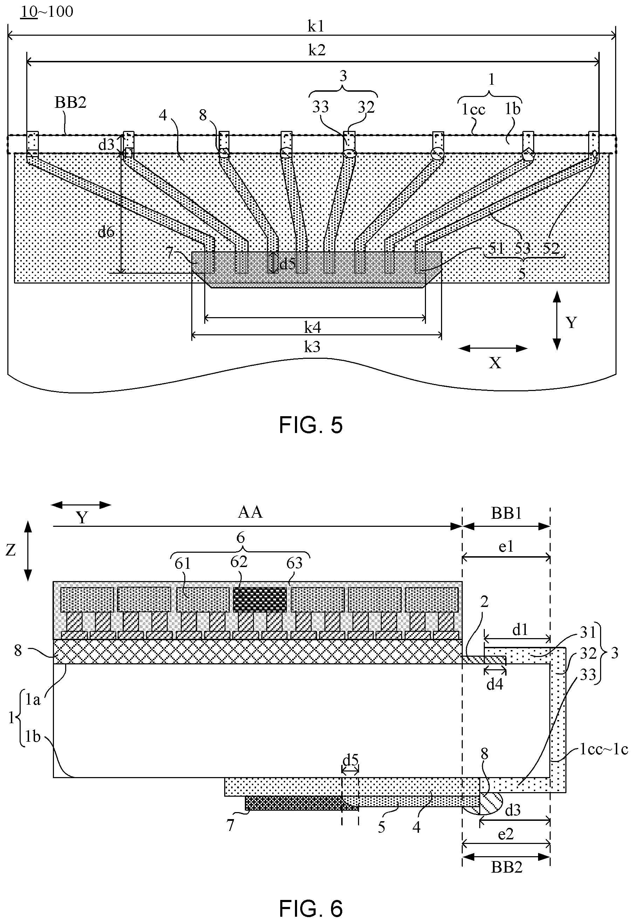

In some other embodiments, as shown in FIG. 5, the second bonding electrode 5 is in a non-linear shape. A plurality of second bonding electrodes 5 are arranged side by side and spaced apart in the first direction X. The second bonding electrode 5 includes a plurality of sub-portions with different extending directions that are connected in sequence. For example, the second bonding electrode 5 includes a first bonding end 51, a connecting portion 53, and a second bonding end 52. The first bonding end 51 is a portion of the second bonding electrode 5 connected to the third portion 33 of the connecting lead 3. The connecting portion 53 is a middle portion of the second bonding electrode 5. The second bonding end 52 is a portion of the second bonding electrode 5 farthest from the selected side face 1cc of the substrate 1.

The first bonding end 51, the connecting portion 53 and the second bonding end 52 of the second bonding electrode 5 extend in different directions, and an included angle between each sub-portion included in the second bonding electrode 5 and the Y direction is not greater than 60°. However, a whole of the second bonding terminal 5 may be considered to extend substantially in a direction perpendicular to the selected side face 1cc of the substrate 1, such as the Y direction shown in FIG. 5. Thus, a length d6 of the second bonding electrode 5 in the non-linear shape is a sum of lengths of orthogonal projections of the plurality of sub-portions included in the second bonding electrode 5 on the substrate 1 in the second direction Y.

For example, as shown in FIG. 5, a dimension k1 of the selected side face 1cc of the substrate 1 in the first direction X is greater than a dimension k2 of an area covered by a plurality of first bonding ends 51 in the first direction X, the dimension k2 of the area covered by the plurality of first bonding ends 51 in the first direction X is greater than a dimension k3 of an area covered by the flexible circuit board 7 in the first direction X, and the dimension k3 of the area covered by the flexible circuit board 7 in the first direction X is greater than a dimension k4 of an area covered by a plurality of second bonding ends 52 in the first direction X. The plurality of second bonding ends 52 are converged inward relative to the plurality of first bonding ends 51, which is suitable for the flexible circuit board 7 with relatively small size.

For example, as shown in FIG. 6, the first bonding electrode 2 extends in the second direction Y, and the first portion 31 of the connecting lead 3 extends in the second direction Y The first bonding electrode 2 and the first portion 31 of the connecting lead 3 that are connected have an overlap portion in the second direction Y, and a dimension d4 in the second direction Y is greater than or equal to zero.

For example, a dimension d1 of the first portion 31 of the connecting lead 3 in a direction perpendicular to the selected side face 1cc of the substrate 1 is greater than zero.

In some embodiments, the dimension d1 of the first portion 31 of the connecting lead 3 in the direction perpendicular to the selected side face 1cc of the substrate 1 is greater than or equal to 60 µm.

The dimension d1 of the first portion 31 of the connecting lead 3 in the direction perpendicular to the selected side face 1cc of the substrate 1 is, for example, 60 µm, 65 µm or 70 µm.

For example, a dimension e1 of the first bonding area BB1 in the direction perpendicular to the selected side face 1cc of the substrate 1 is the same or substantially the same as a dimension e2 of the second bonding area BB2 in the direction perpendicular to the selected side face 1cc of the substrate 1.

For example, a dimension d3 of the third portion 33 of the connecting lead 3 in the direction perpendicular to the selected side face 1cc of the substrate 1 is less than or equal to a distance between an edge of an orthographic projection of the first bonding electrode 2 on the substrate 1 away from the selected side face 1cc and the selected side face 1cc.

In some embodiments, the distance between the edge of the orthographic projection of the first bonding electrode 2 on the substrate 1 away from the selected side face 1cc and the selected side face 1cc is the same as the dimension e1 of the first bonding area BB1 in the direction perpendicular to the selected side face 1cc of the substrate 1. That is, the distance between the edge of the orthographic projection of the first bonding electrode 2 on the substrate 1 away from the selected side face 1cc and the selected side face 1cc is equal to e1. The dimension d3 of the third portion 33 of the connecting lead 3 in the direction (i.e., the second direction Y shown in FIG. 6) perpendicular to the selected side face 1cc of the substrate 1 is less than or equal to the distance e1 between the edge of the orthographic projection of the first bonding electrode 2 on the substrate 1 away from the selected side face 1cc and the selected side face 1cc. That is, d3 ≤ e1.

For example, the dimension d1 of the first portion 31 of the connecting lead 3 in the second direction Y is the same or substantially the same as the dimension d3 of the third portion 33 of the connecting lead 3 in the second direction Y.

In some embodiments, the dimension d1 of the first portion 31 of the connecting lead 3 in the second direction Y is greater than the dimension d3 of the third portion 33 of the connecting lead 3 in the second direction Y, and the dimension d3 of the third portion 33 of the connecting lead 3 in the direction (i.e., the second direction Y shown in FIG. 6) perpendicular to the selected side face 1cc of the substrate 1 is less than or equal to the distance e1 between the edge of the orthographic projection of the first bonding electrode 2 on the substrate 1 away from the selected side face 1cc and the selected side face 1cc. That is, d1 > d3 and d3 ≤ e1.

In some other embodiments, the dimension d1 of the first portion 31 of the connecting lead 3 in the second direction Y is equal to the dimension d3 of the third portion 33 of the connecting lead 3 in the second direction Y, and the dimension d3 of the third portion 33 of the connecting lead 3 in the direction (i.e., the second direction Y shown in FIG. 6) perpendicular to the selected side face 1cc of the substrate 1 is less than or equal to the distance e1 between the edge of the orthographic projection of the first bonding electrode 2 on the substrate 1 away from the selected side face 1cc and the selected side face 1cc. That is, d1 = d3 ≤ e1.

In yet other embodiments, the dimension d1 of the first portion 31 of the connecting lead 3 in the second direction Y is less than the dimension d3 of the third portion 33 of the connecting lead 3 in the second direction Y, and the dimension d3 of the third portion 33 of the connecting lead 3 in the direction (i.e., the second direction Y shown in FIG. 6) perpendicular to the selected side face 1cc of the substrate 1 is less than or equal to the distance e1 between the edge of the orthographic projection of the first bonding electrode 2 on the substrate 1 away from the selected side face 1cc and the selected side face 1cc. That is, d1 < d3 ≤ e1.

It can be understood that an orthographic projection of the first portion 31 of the connecting lead 3 on the display surface 1a of the substrate 1 has no overlap with the display area AA, and an area of the display surface 1a of the substrate 1 corresponding to an orthographic projection of the third portion 33 of the connecting lead 3 on the non-display surface 1b of the substrate 1 has no overlap with the display area AA. That is, the orthographic projection of the first portion 31 of the connecting lead 3 on the display surface 1a of the substrate 1 does not extend to the display area AA, and the area of the display surface 1a of the substrate 1 corresponding to the orthographic projection of the third portion 33 of the connecting lead 3 on the non-display surface 1b of the substrate 1 does not extend to the display area AA. Therefore, when forming the plurality of connecting leads 3, there are no reliability problems such as local corrosion caused by damage to the film layers and devices within the display area AA by laser emitted from a side of the display surface 1a of the substrate 1 or from a side of the non-display surface 1b of the substrate 1.

For example, the display panel 10 further includes a flexible circuit board 7, ends of a plurality of second bonding electrodes 5 on the electrode carrier plate 4 are configured to be electrically connected to the flexible circuit board 7, and the other ends of the plurality of second bonding electrodes 5 are configured to be electrically connected to the plurality of connecting leads 3. The flexible circuit board 7 is disposed on a side of the plurality of second bonding electrodes 5 away from the substrate 1. The flexible circuit board 7 is configured to transmit signals to the driving circuit layer Q to drive the plurality of light-emitting devices 61 in the light-emitting device layer 6 to emit light.

When the display panel 10 is manufactured, the electrode carrier plate 4 and the plurality of second bonding electrodes 5 disposed on the side of the electrode carrier plate 4 away from the substrate 1 are integrated as a whole to achieve fixation on the substrate 1. For example, a connecting glue is provided on a side of the electrode carrier plate 4 proximate to the substrate 1, and the electrode carrier plate 4 is attached to the non-display surface 1b of the substrate 1, then each second bonding electrode 5 is connected to a connecting lead 3 to lead the front circuit of the display panel to the back. The connecting glue is, for example, an adhesive 92. For the provision position and the shape of the connecting glue, reference may be made to the description of the adhesive 92 below.

By providing the electrode carrier plate 4, only the plurality of second bonding electrodes 5 are formed on the electrode carrier plate 4. When the plurality of second bonding electrodes 5 are formed on the electrode carrier plate 4, the electrode carrier plate 4 is not connected to the substrate 1. Referring to FIGS. 1 and 6, such a design may shorten the dimension of the third portion 33 of the connecting lead 3 in the second direction Y

As shown in FIG. 1, an end of the third portion 33 of the connecting lead 3 away from the selected side face 1cc of the substrate 1 is configured to be connected to the flexible circuit board 7. As shown in FIG. 6, the dimension of the third portion 33 of the connecting lead 3 in the second direction Y is shortened from d2 to d3, and the second bonding ends 52 of the plurality of second bonding electrodes 5 replace shortened portions of the third portions 33 of the connecting leads 3 to achieve connection with the flexible circuit board 7. On a premise of ensuring stable and effective transmission of signals, it may avoid reliability problems such as local corrosion caused by damage to the film layers and devices within the display area AA by the laser when the plurality of connecting leads 3 are formed, thereby improving the reliability of the display panel 10.

For example, as shown in FIGS. 2 and 3, the display surface 1a and the non-display surface 1b of the substrate 1 are each in a rectangular shape, and the substrate 1 includes four side faces 1c.

In the following, a plurality of first bonding electrodes 2 provided proximate to each selected side face 1cc of the substrate 1 are referred to as a group of first bonding electrodes 2, a plurality of connecting leads provided proximate to each selected side face 1cc of the substrate 1 are referred to as a group of the plurality of connecting leads 3, and a plurality of second bonding electrodes 5 provided on each electrode carrier plate 4 are referred to as a group of second bonding electrodes 5. The cases of the substrate 1 including different numbers of selected side faces 1cc are explained.

In some embodiments, as shown in FIG. 2, the substrate 1 includes two opposite selected side faces 1cc. Further, the display panel 10 includes two groups of first bonding electrodes 2, two groups of connecting leads 3, and two electrode carrier plates 4 on each of which a plurality of second bonding electrodes 5 are formed. Each group of first bonding electrodes 2 are disposed proximate to a selected side face 1cc, and are connected to a group of second bonding electrodes 5 by a group of connecting leads 3.

In some other embodiments, as shown in FIG. 3, the substrate 1 includes a single selected side faces 1cc. Further, the display panel 10 includes a group of first bonding electrodes 2, a group of connecting leads 3, and an electrode carrier plate 4 on which a plurality of second bonding electrodes 5 are formed. Each group of first bonding electrodes 2 are disposed proximate to the selected side face 1cc, and are connected to a group of second bonding electrodes 5 by a group of connecting leads 3.

For example, the material of the substrate 1 is a rigid material such as glass, quartz and plastic.

It can be understood that the above material of the substrate 1 is only examples of a possible implementation, and the material of the substrate 1 includes but is not limited to the above examples.

In order to ensure stable and effective transmission of signals, the first bonding electrodes 2, the connecting leads 3 and the second bonding electrodes 5 should have good conductive properties.

In some embodiments, the materials of the first bonding electrodes 2, the connecting leads 3 and the second bonding electrodes 5 include metal.

For example, the materials of the first bonding electrodes 2, the connecting leads 3 and the second bonding electrodes 5 include at least one of copper, titanium, aluminum, molybdenum, or nickel alloy.

In some other embodiments, the materials of the connecting leads 3 and the second bonding electrodes 5 include conductive metal colloid.

For example, the materials of the connecting leads 3 and the second bonding electrodes 5 include conductive silver adhesive. Further, the conductive silver adhesive is, for example, a mixture of silver nanoparticles and colloid.

In some examples, the above conductive silver adhesive is isotropic conductive adhesive (ICA).

In some other examples, the above conductive silver adhesive is anisotropic conductive adhesive (ACA).

In yet other examples, the materials of the connecting leads 3 and the second bonding electrodes 5 include anisotropic conductive films (ACFs).

It can be understood that the above materials of the first bonding electrodes 3, the connecting leads 3 and the second bonding electrodes 5 are only examples as a possible implementation. The materials of the first bonding electrodes 3, the connecting leads 3 and the second bonding electrodes 5 include but are not limited to the above examples.

For example, as shown in FIGS. 4, 5 and 6, the display panel 10 further includes a flexible circuit board 7 provided on a side of the plurality of second bonding electrodes 5 away from the substrate 1. Each second bonding electrode 5 extends in the second direction Y Each second bonding electrode 5 includes a first bonding end 51 and a second bonding end 52. The first bonding end 51 of the second bonding electrode 5 is configured to be electrically connected to the flexible circuit board 7. The second bonding end 52 of the second bonding electrode 5 is configured to be electrically connected to the third portion 33 of the connecting lead 3.

Portions of the flexible circuit board 7 and the first bonding end 51 of the second bonding electrode 5 that are connected have an overlap. A dimension of the overlapping portion of the flexible circuit board 7 and the first bonding end 51 of the second bonding electrode 5 in the second direction Y is called an overlap distance of the flexible circuit board 7. In a case where the overlap distance is too small, there is a risk that the flexible circuit board 7 and the first bonding end 51 of the second bonding electrode 5 are disconnected, resulting in an unreliable connection between the flexible circuit board 7 and the first bonding end 51 of the second bonding electrode 5. When the flexible circuit board 7 and the first bonding end 51 of the second bonding electrode 5 are disconnected, the control signals will not be transmitted normally, resulting in abnormal work of the display panel 10. Therefore, in order to ensure the stable and effective connection between the flexible circuit board 7 and the plurality of second bonding electrodes, the dimension d5 of the overlapping portion of the flexible circuit board 7 and the first bonding end 51 of the second bonding electrode 5 in the second direction Y should ensure a stable and effective connection between the flexible circuit board 7 and the first bonding end 51 of the second bonding electrode 5.

In some embodiments, the dimension d5 of the overlapping portion of the flexible circuit board 7 and the first bonding end 51 of the second bonding electrode 5 in the second direction Y is greater than or equal to 0.5 mm.

The dimension d5 of the overlapping portion of the flexible circuit board 7 and the first bonding end 51 of the second bonding electrode 5 in the second direction Y is, for example, 0.5 mm, 1 mm or 2 mm.

In some embodiments, a plurality of second bonding electrodes 5 provided on the electrode carrier plate 4 are formed by printing.

For example, the plurality of second bonding electrodes 5 are formed by 3D printing, screen transfer printing, pad printing/transfer printing, or stencil printing.

It can be understood that when the plurality of second bonding electrodes 5 are formed by, for example, printing, since the process of forming the plurality of second bonding electrodes 5 does not involve a laser process, the plurality of second bonding electrodes 5 may be directly formed on the non-display surface 1b of the substrate 1 without providing an additional electrode carrier plate 4, and may not affect the film layer structure within the display area AA.

In some other embodiments, a plurality of second bonding electrodes 5 are formed by, for example, sputtering coating and laser etching. For example, a metal film is first formed on the electrode carrier plate 4 by sputtering coating, and then the metal film is etched by laser to form conductive patterns, which are the plurality of second bonding electrodes 5.

The material of the plurality of second bonding electrodes 5 provided on the electrode carrier plate 4 includes a conductive material, and the plurality of second bonding electrodes 5 arranged side by side are electrically insulated from each other. Therefore, the electrode carrier plate 4 may be made of an insulated material, thereby avoiding affecting the normal work of the display panel 10 due to the inability of the driving signals provided by external controller(s), such as the flexible circuit board 7 and/or a driver chip, to be transmitted to the display area AA normally caused by short-circuit between multiple second bonding electrodes 5 through the electrode carrier plate 4.

The short-circuit here means that at least two second bonding electrodes 5 that should not have an electrical connection among the plurality of second bonding electrodes 5 are conductive through the electrode carrier plate 4, so that a loop is formed between the at least two second bonding electrodes 5 that should not have an electrical connection but are conductive through the electrode carrier plate 4, resulting in the short circuit.

When the plurality of second bonding electrodes 5 are formed by, for example, coating and laser etching, during laser etching, the energy of the laser will generate a large amount of heat to cause the electrode carrier plate 4 to be heated. Therefore, the electrode carrier plate 4 may have good high temperature resistance.

For example, the material of the electrode carrier plate 4 includes an insulated material.

In some embodiments, the material of the electrode carrier plate 4 includes glass or a polyimide film (PI film).

In some other embodiments, the electrode carrier plate 4 includes a high temperature resistant material. When the second bonding electrode 5 is formed on the electrode carrier plate 4 by sputtering coating and laser etching, a large amount of heat will be generated. The high temperature resistance mentioned here refers to that when the second bonding electrodes 5 are formed on the electrode carrier plate 4, the electrode carrier plate 4 may not be affected in properties and shape by heat, so as to prevent the electrode carrier plate 4 and the second bonding electrodes 5 from being unable to be connected to the connecting lead 3 normally due to deformation of the electrode carrier plate 4 when subjected to the high temperature, thereby ensuring the normal work of the display panel 10.

It can be understood that the above material of the electrode carrier plate 4 is only examples of a possible implementation, and the material of the electrode carrier plate 4 includes but is not limited to the above examples.

In some embodiments, the display panel 10 further includes a plurality of connection pads 8 located on a side of the plurality of second bonding electrodes 5 away from the substrate 1. The plurality of connection pads 8 are arranged side by side and at intervals, and each connection pad 8 is connected to a second bonding electrode 5 and a third portion 33 of a connecting lead 3.

In some embodiments, the material of the connection pad 8 includes metal.

For example, the material of the connection pad 8 includes at least one of copper, titanium, aluminum, molybdenum, nickel alloy or conductive silver adhesive.

In some other embodiments, the material of the connection pad 8 includes conductive adhesive.

In some examples, the conductive adhesive is ICA.

In some other examples, the conductive adhesive is ACA.

In yet other examples, the conductive adhesive is ACF.

In a case where the material of the connection pad 8 is, for example, ACA or ACF, the ACA or ACF may conduct electricity in only a single direction such as the Y direction, and may also serve as an adhesive to achieve a adhesion effect, while does not conduct electricity in the X direction and a Z direction, and only serves as an adhesive to achieve a adhesion effect.

It can be understood that the ACA or ACF may only conduct electricity in the Y direction. Therefore, the ACA or ACF may be provided between the second bonding terminal 5 and the third portion 33 of the connecting lead 3. Moreover, in the Y direction, an end of the ACA or ACF is connected to the second bonding terminal 5, and the other end of the ACA or ACF is connected to the third portion 33 of the connecting lead 3, thereby realizing the conduction between the second bonding terminal 5 and the third portion 33 of the connecting lead 3. In addition, since the ACA or ACF is not conductive in the X direction, the plurality of connection pads may be in contact with each other in the X direction. It can be understood that the above material of the connection pads 8 is only examples of a possible implementation, and the material of the connection pad 8 includes but is not limited to the above examples.

In order to ensure a stable connection between the connecting lead 3 and the second bonding electrode 5, a size of the connection pad 8 configured to connect the second bonding electrode 5 and the connecting lead 3 will meet the connection requirements. The shape and size of the connection pad 8 are introduced below.

For example, as shown in FIGS. 4 and 5, a shape of an orthogonal projection of the connection pad 8 on the substrate 1 includes a circle, an ellipse, a triangle, a star, a square, a heart, a trapezoid, or the like. The connection pad 8 need to be able to achieve conduction between the second bonding electrode 5 and the connecting lead 3, and not cause short-circuit between at least two second bonding electrodes 5 that should not have an electrical connection among the plurality of second bonding electrodes or short-circuit between at least two connecting leads 3 that should not have a connection among the plurality of connecting leads 3.

The short-circuit here refers to that at least two second bonding electrodes 5 that should not have a connection among the plurality of second bonding electrodes 5 or at least two connecting leads 3 that should not have a connection among the plurality of connecting leads 3 are conductive to form a loop, resulting in the short circuit.

For example, as shown in FIG. 7, the second bonding area BB2 extends in the first direction X, and the third portion 33 of the connecting lead 3 extends in the second direction Y. The first direction X intersects the second direction Y A dimension r3 of the connection pad 8 in the first direction X is greater than one third of a dimension r1 of the third portion 33 of the connecting lead 3 connected to the connection pad 8 in the first direction X. That is, r3 > (1/3) × r1.

For example, as shown in FIG. 7, a sum of the dimension r1 of the third portion 33 of the connecting lead 3 connected to the second bonding electrode 5 in the first direction X and a distance r2 between third portions 33 of two adjacent connecting leads 3 in the first direction X is greater than the dimension r3 of the connection pad 8 in the first direction X. That is, (r1 + r2) > r3.

In some embodiments, the dimension r3 of the connection pad 8 in the first direction X is less than the dimension r1 of the third portion 33 of the connecting lead 3 connected to the connection pad 8 in the first direction X. That is, r3 < r1.

In some other embodiments, the dimension r3 of the connection pad 8 in the first direction X is equal to the dimension r1 of the third portion 33 of the connecting lead 3 connected to the connection pad 8 in the first direction X. That is, r3 = r1.

In some other embodiments, the dimension r3 of the connection pad 8 in the first direction X is greater than the dimension r1 of the third portion 33 of the connecting lead 3 connected to the connection pad 8 in the first direction X, and a sum of the dimension r1 of the third portion 33 of the connecting lead 3 connected to the second bonding electrode 5 in the first direction X and the distance r2 between third portions 33 of two adjacent connecting leads 3 in the first direction X is greater than the dimension r3 of the connection pad 8 in the first direction X. That is, r3 > r1, and (r1 + r2) > r3.

For example, as shown in FIG. 7, a dimension r4 of the connection pad 8 in a direction perpendicular to the selected side face 1cc of the substrate 1 is less than or equal to a distance r5 between an edge of the orthographic projection of the second bonding electrode 5 connected to the connection pad 8 on the substrate 1 away from the selected side face 1cc and the selected side face 1cc. That is, r4 ≤ r5.

In some embodiments, as shown in FIG. 7, a dimension r4 of the connection pad 8 in a direction perpendicular to the selected side face 1cc of the substrate 1 is greater than or equal to 30 µm.

The dimension r4 of the connection pad 8 in the direction perpendicular to the selected side face 1cc of the substrate 1 is, for example, 30 µm, 35 µm or 40 µm.

In some embodiments, as shown in FIG. 7, a distance r5 between an edge of an orthographic projection of each of the plurality of second bonding electrodes 5 on the substrate 1 away from the selected side face 1cc of the substrate 1 and the selected side face 1cc is greater than or equal to 3 mm.

In some embodiments, as shown in FIG. 7, the distance r5 between the edge of the orthographic projection of each of the plurality of second bonding electrodes 5 on the substrate 1 away from the selected side face 1cc of the substrate 1 and the selected side face 1cc is less than or equal to 200 mm.

The distance r5 between the edge of the orthographic projection of each of the plurality of second bonding electrodes 5 on the substrate 1 away from the selected side face 1cc of the substrate 1 and the selected side face 1cc is, for example, 3 mm, 60 mm, 100 mm or 200 mm.

In some embodiments, as shown in FIG. 8, a dimension d11 of the first portion 31 of the connecting lead 3 connected to the first bonding electrode 2 in a direction perpendicular to an extending direction of the first portion 31 of the connecting lead 3 is greater than or equal to 30% of a dimension d12 of the first bonding electrode 2 in a direction perpendicular to an extending direction of the first bonding electrode 2. That is, d11 ≥ d12 × 30%.

In some embodiments, as shown in FIG. 8, a difference between a sum of the dimension d12 of the first bonding electrode 2 in a direction perpendicular to an extending direction of the first bonding electrode 2 and a distance d13 between two adjacent first bonding electrodes 2 in the direction perpendicular to the extending direction of the first bonding electrodes 2 and a distance d14 between first portions 31 of two adjacent connecting leads 3 in a direction perpendicular to an extending direction of the first portions 31 of the two connecting leads 3 is greater than or equal to a dimension d11 of the first portion 31 of the connecting lead 3 connected to the first bonding electrode 2 in the direction perpendicular to the extending direction of the first portion 31 of the connecting lead 3. That is, d12 + d13 - d14 ≥ d11.

In some embodiments, as shown in FIG. 9, portions of the second bonding end 52 of the second bonding electrode 5 and the third portion 33 of the connecting lead 3 that are connected have an overlap. A sum of a dimension d3 of the third portion 33 of the connecting lead 3 in a direction perpendicular to the selected side face 1cc and a dimension d9 of the second bonding electrode 5 in the direction perpendicular to the selected side face 1cc is equal to a sum of a distance d10 between an edge of the orthographic projection of the second bonding electrode 5 on the substrate 1 away from the selected side face 1cc and the selected side face 1cc and a dimension d7 of the portion of the second bonding end 52 overlapped with the third portion 33 of the connecting lead 3 in the direction perpendicular to the selected side face 1cc. That is, d3 + d9 = d10 + d7.

The above overlap refers to an overlap between orthographic projections on the substrate 1. It can be understood that the second bonding end 52 of the second bonding electrode 5 and the third portion 33 of the connecting lead 3 may be or not be in direct contact.

For example, as shown in FIGS. 9, 10, 15 and 16, the electrode carrier plate 4 is provided therein with a plurality of connecting via holes 41 arranged side by side and spaced apart. The second bonding electrode 5 includes a first bonding end 51 and a second bonding end 52. The first bonding end 51 of the second bonding electrode 5 is located on a side of the electrode carrier plate 4 away from the substrate 1. The second bonding end 52 of the electrode 5 passes through a connecting via hole 41 to be electrically connected to a third portion 33 of a connecting lead 3.

In this case, the cross-sectional shape of the second bonding electrode 5 includes several cases as follows.

In some embodiments, as shown in FIGS. 9, 10 and 11, a section of the second bonding electrode 5 is made along a section line DD shown in FIG. 10 or along a section line EE shown in FIG. 11, and the cross-sectional shape of the second bonding electrode 5 is in a shape of L. The plurality of second bonding electrodes 5 are located on a side of the third portions 33 of the plurality of connecting leads 3 away from the substrate 1. The third portions 33 of the plurality of connecting leads 3 mentioned here are portions of the plurality of connecting leads 3 located on the non-display surface 1b of the substrate 1.

For example, a plurality of second bonding electrodes 5 are arranged side by side and spaced apart in the first direction X. The second bonding end 52 of the second bonding electrode 5 passes through a connecting via hole 41 in the electrode carrier plate 4 to be electrically connected to a third portion 33 of a connecting lead 3. The first bonding end 51 of the second bonding electrode 5 is located on a side of the third portion 33 of the connecting lead 3 away from the substrate 1. The first bonding end 51 of the second bonding electrode 5 is configured to be connected to the flexible circuit board 7. The end of the second bonding end 52 of the second bonding electrode 5 connected to the third portion 33 of the connecting lead 3 is flush with or substantially flush with a surface of the electrode carrier plate 4 proximate to the substrate 1.

The second bonding end 52 of the second bonding electrode 5 extends toward the third portion 33 of the connecting lead 3. In some examples, as shown in FIG. 9, the second bonding end 52 of the second bonding terminal 5 includes a portion located within the connecting via hole 41, and the second bonding end 52 extends in the third direction Z. The first bonding end 51 of the second bonding terminal 5 is a portion thereof connected to the flexible circuit board. The connecting portion 53 of the second bonding terminal 5 is a portion between the first bonding end 51 and the second bonding end 52. Both the connecting portion 53 and the first bonding end 51 extend in a plane perpendicular to the third direction Z. For example, a dimension of the second bonding end 52 of the second bonding electrode 5 in the third direction Z is greater than a dimension of the second bonding end 52 of the second bonding electrode 5 in the third direction Z and/or a dimension of the connecting portion 53 of the second bonding electrode 5 in the third direction Z.

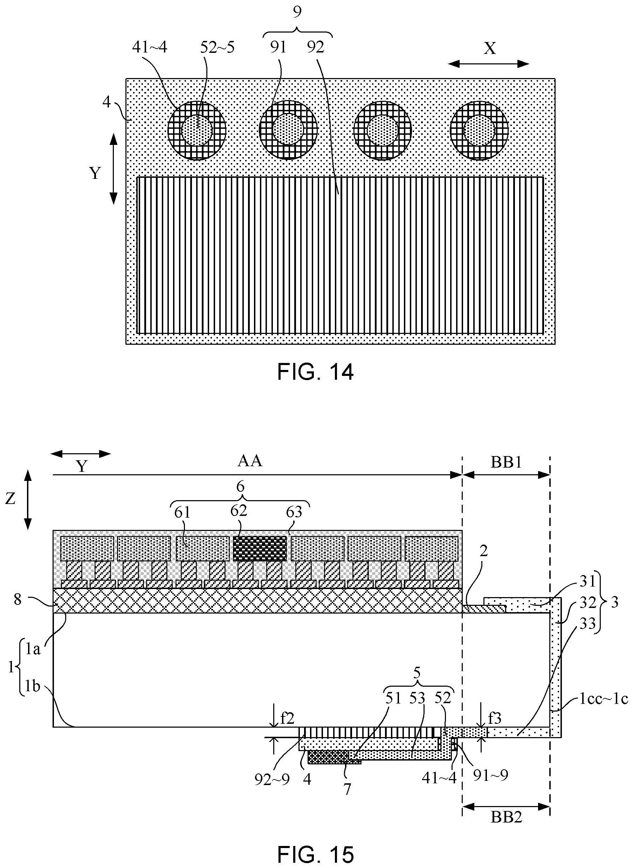

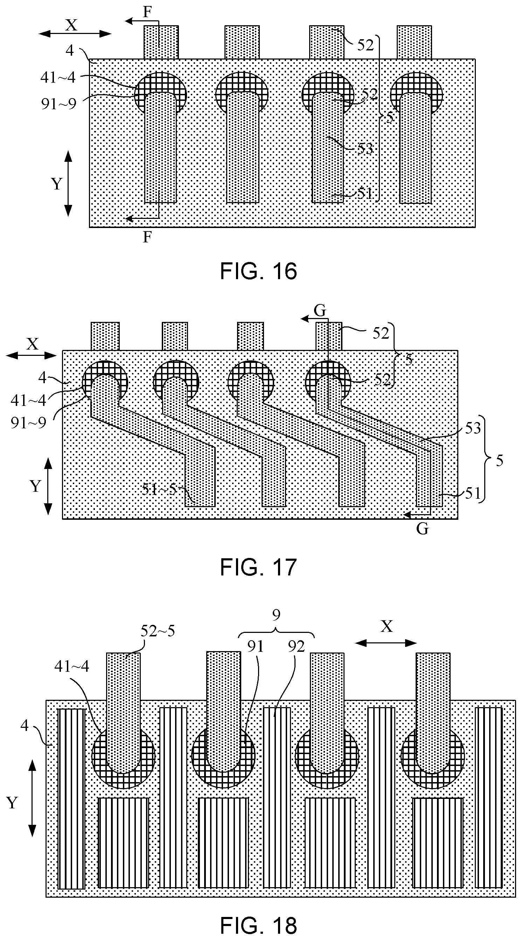

In some other embodiments, as shown in FIGS. 15, 16 and 17, a section of the second bonding electrode 5 is made along a section line FF shown in FIG. 16 or along a section line GG shown in FIG. 17, and the cross-sectional shape of the second bonding electrode 5 is in a shape of Z. The first bonding end 51 of the second bonding electrode 5 is located on a side of the electrode carrier plate 4 away from the substrate 1, and the second bonding end 52 of the second bonding electrode 5 includes a first portion thereof located on a side of the electrode carrier plate 4 proximate to the substrate 1 and a second portion located within a connecting via hole 41. The second bonding end 52 is in a shape of L in the cross-sectional view shown in FIG. 15. The second bonding end 52 of the second bonding electrode 5 is connected to the third portion 33 of the connecting lead 3. The first bonding end 51 of the second bonding terminal 5 is a portion thereof connected to the flexible circuit board. The connecting portion 53 of the second bonding terminal 5 is a portion between the first bonding end 51 and the second bonding end 52. Both the connecting portion 53 and the first bonding end 51 extend in a plane perpendicular to the third direction Z.

In some examples, as shown in FIG. 15, both the first bonding end 51 and the first portion of the second bonding end 52 of the second bonding electrode 5 extend in the second direction Y A sum of dimensions of the first bonding end 51 and the connecting portion 53 of the second bonding electrode 5 in the second direction Y is greater than a dimension of the second bonding end 52 of the second bonding electrode 5 in the second direction Y

For example, the display panel 10 further includes a plurality of connection structures 9, and each connection structure 9 is configured to connect the first bonding end 51 of the second bonding electrode 5 and the third portion 33 of the connecting lead 3. The connection structure 9 includes a binder 91 and/or an adhesive 92.

The position, shape and material of the connection structure 9 are introduced below.

In some embodiments, as shown in FIGS. 9, 10 and 11, the connection structure 9 includes a binder 91, and the binder 91 is configured to connect the second bonding end 52 and the third portion 33 of the connecting lead 3. The second bonding end 52 is located on a side of the third portion 33 of the connecting lead 3 connected to the second bonding end 52 away from the substrate 1. The binder 91 is disposed within the connecting via hole 41.

The binder 91 needs to be filled into the connecting via hole 41 in the electrode carrier plate 4. Therefore, the binder needs to have fluidity and be able to solidify after being filled into the connecting via hole 41 in the electrode carrier plate 4, thereby ensuring a stable connection between the second bonding electrode 5 and the connecting lead 3.

In some embodiments, the binder 91 includes glue. The colloid of the glue meets the bonding resistance condition. For example, the glue will at least meet the requirements of not deforming or not visbreaking of the colloid within 7 minutes at an ambient temperature of 200°C.

In some examples, the above glue is an insulating adhesive with good viscosity. As a possible design, the binder 91 is a curable liquid glue, and a thickness of the binder 91 after curing does not exceed a thickness of the second bonding electrode 5, where the thickness refers to a dimension in a direction perpendicular to the display surface 1a of the substrate 1. The flow range of the binder 91 is less than 1 mm.

By considering an example where an orthogonal projection of the connecting via hole 41 on the substrate 1 is a circle, a radius of the orthogonal projection of the connecting via hole 41 on the substrate 1 is R mm. Taking a center of the circle of the circular orthogonal projection of the connecting via hole 41 on the substrate 1 as a reference point, a circle with a radius of (R+1) mm and with the reference point as the center is determined. The flow range of the binder 91 is less than 1 mm, which means that an orthographic projection of the cured binder 91 on the substrate 1 is within the circle with the radius of (R+1) mm.

It can be understood that the above content is an exemplary description for clearly describing the flow range of the binder 91 instead of limitation of the present disclosure. The shape of the orthogonal projection of the connecting via hole 41 on the substrate 1 includes but is not limited to a circle, and may also be an ellipse, a square or a polygon, as long as the flow range of the cured binder 91 does not exceed 1 mm from the edge of the connecting via hole 41.

In some other examples, the above glue is conductive adhesive, which has good viscosity and conductivity. An orthographic projection of the glue on the non-display surface 1b of the substrate 1 overlaps or substantially overlaps with an orthogonal projection of the connecting via hole 41 on the non-display surface 1b of the substrate 1, so as to ensure the electrical connection between the second bonding terminal 5 and the connecting lead 3.

As a possible design, the glue is, for example, silver adhesive.

It can be understood that the connecting lead 3 and the second bonding electrode 5 may achieve electrical connection through direct contact, or achieve electrical connection indirectly through conductivity and adhesiveness of the binder 91.

In some embodiments, the binder 91 bonds the second bonding end 52 of the second bonding electrode 5 to the third portion 33 of the connecting lead 3, so that the relative position between the second bonding end 52 of the second bonding electrode 5 and the third portion 33 of the connecting lead 3 remains unchanged, thereby ensuring a stable connection between the two.

In some other embodiments, by using a binder 91 with good conductivity, the second bonding end 52 of the second bonding electrode 5 and the third portion 33 of the connecting lead 3 may be in direct contact to achieve connection and conduction, or achieve connection through indirect conduction by the binder 91.

It can be understood that no matter whether the second bonding end 52 of the second bonding electrode 5 and the third portion 33 of the connecting lead 3 are in direct contact to achieve connection and conduction, or achieve indirect conduction by the binder 91, the effective conduction between the second bonding electrode 5 and the connecting lead 3 may be achieved, thereby ensuring normal transmission of signals.

In some other embodiments, as shown in FIGS. 9, 10 and 11, a section of the second bonding electrode 5 is made along a section line DD shown in FIG. 10 or along a section line EE shown in FIG. 11, and the cross-sectional shape of the second bonding electrode 5 is in a shape of L. The connection structure 9 includes an adhesive 92 disposed on a side of the second bonding end 52 of the second bonding electrode 5 away from the selected side face 1cc of the substrate 1, and is configured to bond the electrode carrier plate 4 and the substrate 1. A surface of the adhesive 92 is bonded to a surface of the electrode carrier plate 4 proximate to the substrate 1, and the other surface of the adhesive 92 faces the substrate 1.

For example, the adhesive 92 is an insulating adhesive with good viscosity. In some examples, the adhesive 92 is a textured adhesive or a pressure-sensitive adhesive.

For example, as shown in FIG. 9, the second bonding end 52 of the second bonding electrode 5 is located on a side of the third portion 33 of the connecting lead 3 connected thereto away from the substrate 1, and the adhesive 92 is located between the electrode carrier plate 4 and substrate 1. In a direction perpendicular to the electrode carrier plate 4 (e.g., the third direction Z shown in FIG. 9), a dimension f2 of the adhesive 92 is the same or substantially the same as a dimension f1 of the third portion 33 of the connecting lead 3.

In some embodiments, a thickness of the adhesive 92 in a direction perpendicular to the non-display surface 1b of the substrate 1 is greater than or equal to 10 µm. The thickness of the adhesive 92 in the direction perpendicular to the non-display surface 1b of the substrate 1 is, for example, 10 µm, 13 µm, or 17 µm.

The description of the thickness of the adhesive 92 here is only provided as a possible design for illustration, and does not serve as limitation on the dimension of the adhesive 92.

For example, as shown in FIG. 9, the adhesive 92 is disposed on a side of the second bonding end 52 of the second bonding electrode 5 located on a side of the third portion 33 of the connecting lead 3 connected thereto away from the substrate 1. The distance between the adhesive 92 and a side of the third portion 33 of the connecting lead 3 opposite thereto is greater than or equal to zero. That is, the adhesive 92 is in direct contact or not in direct contact with the side of the third portion 33 of the connecting lead 3 opposite thereto.

As shown in FIG. 9, at least part of an end of the third portion 33 of the connecting lead 3 away from the selected side face 1cc of the substrate 1 is located between the electrode carrier plate 4 and the substrate 1. It can be understood that at least part of a gap will be generated between electrode carrier plate 4 and substrate 1 in addition to the space occupied by the third portion 33 of the connecting lead 3, the adhesive 92 is provided to fill in the above gap, thereby realizing smooth attachment of the electrode carrier plate 4, and further realizing smooth attachment of the second bonding electrode 5. Thus, it may ensure a stable and effective connection between the second bonding electrode 5 and the connecting lead 3, and avoid abnormal display of the display panel 10 caused by abnormal transmission of control signals, which is caused by easy disconnection of the connecting portion between the second bonding electrode 3 and the connecting lead 3 due to a large distance between an end of the second bonding electrode 3 connected to the connecting lead 3 and the substrate 1.

For example, an orthographic projection of the electrode carrier plate 4 on the substrate 1 partially overlaps with an orthographic projection of the third portion 33 of the connecting lead 3 on the substrate 1, and an orthographic projection of the adhesive 92 on the substrate 1 does not overlap with the orthographic projection of the third portion 33 of the connecting lead 3 on the substrate 1. It can be understood that the adhesive 92 is disposed in an area, except for an overlap area between the second bonding electrode 5 and the third portion 33 of the connecting lead 3, on a side of the electrode carrier plate 4 proximate to the substrate 1.

It can be understood that the provision of the adhesive 92 may ensure an effective and stable connection between the second bonding end 52 of the second bonding electrode 5 and the third portion 33 of the connecting lead 3. The provision of the adhesive 92 enable a surface of the electrode carrier plate 4 and an opposite surface of the substrate 1 to be parallel or substantially parallel, thereby avoiding inability to achieve electrical connection caused by a distance between the second bonding end 52 of the second bonding electrode 5 and the third portion 33 of the connecting lead 3 exceeding a preset distance due to a large angle between the surface of the electrode carrier plate 4 and the opposite surface of the substrate 1, for example, a distance between a side of the electrode carrier plate 4 proximate to the selected side face 1cc of the substrate 1 and the substrate 1 is greater than a distance between a side of the electrode carrier plate 4 away from the selected side face 1cc of the substrate 1 and the substrate 1.

When the electrode carrier plate 4 provided with a plurality of second bonding electrodes 5 thereon is disposed on the non-display surface 1b of the substrate 1, a second bonding end 52 of each second bonding electrode 5 in the plurality of second bonding electrodes 5 will pass through a connecting via hole 41 to be in direct contact with a third portion 33 of a connecting lead 3 to achieve electrical connection, or be in indirect contact through the binder 91 filled in the connecting via hole 41 to achieve electrical connection.

It will be noted that in a case where the second bonding end 52 of the second bonding electrode 5 is in direct contact with the third portion 33 of the connecting lead 3, the distance between the two is zero. In a case where the second bonding end 52 of the second bonding electrode 5 and the third portion 33 of the connecting lead 3 are in indirect contact through the binder 91, there is a certain distance between the two. However, the binder 91 is, for example, conductive glue, there will be a part of the binder 91 filled in the connecting via hole 41 in the electrode carrier plate 4 overflowing toward the substrate 1, and after the binder 91 is cured, a stable connection between the second bonding end 52 of the second bonding electrode 5 and the third portion 33 of the connecting lead 3 may be achieved.

It can be understood that the connection stability between the electrode carrier plate 4 and the substrate 1 may increase by providing the adhesive 92. As shown in FIGS. 12, 13 and 14, the adhesive 92 includes, for example, a plurality of long strips of adhesive 92 arranged side by side and spaced apart; alternatively, the adhesive 92 has a network structure; alternatively, the adhesive 92 has a block structure. Thus, a bonding area between the electrode carrier plate 4 and the substrate 1 may increase, thereby achieving a rather stable connection between the two.

In some other embodiments, as shown in FIGS. 15, 16 and 17, a section of the second bonding electrode 5 is made along a section line FF shown in FIG. 16 or along a section line GG shown in FIG. 17, and the cross-sectional shape of the second bonding electrode 5 is in a shape of Z. The connection structure 9 includes an adhesive 92, which is provided on a side of the second bonding end 52 of the second bonding electrode 5 away from the selected side face 1cc of the substrate 1, and is configured to bond the electrode carrier plate 4 and the substrate 1. A surface of the adhesive 92 is bonded to a surface of the electrode carrier plate 4 proximate to the substrate 1, and the other surface of the adhesive 92 faces the substrate 1.

The first bonding end 51 of the second bonding electrode 5 is located on a side of the electrode carrier plate 4 away from the substrate 1, and the second bonding end 52 of the second bonding electrode 5 is located on a side of the electrode carrier plate 4 proximate to the substrate 1. Both the first bonding end 51 and the second bonding end 52 of the second bonding electrode 5 and the third portion 33 of the connecting lead 3 all extend in the second direction Y

It will be noted that the extending directions of both the first bonding end 51 and the second bonding end 52 of the second bonding electrode 5 and the third portion 33 of the connecting lead 3 refer to overall extending directions thereof. That is, a whole of any of the first bonding end 51 and the second bonding end 52 of the second bonding electrode 5 or the third portion 33 of the connecting lead 3 may be in a linear or non-linear shape. For the specific shapes of both the first bonding end 51 and the second bonding end 52 of the second bonding electrode 5 or the third portion 33 of the connecting lead 3, reference may be made to the above description for the third portion 33 of the connecting lead 3 and the second bonding electrode 5, and details are not repeated here.

As shown in FIGS. 15, 18, 19 and 20, the adhesive 92 is located between the electrode carrier plate 4 and the substrate 1. In a direction perpendicular to the electrode carrier plate 4, a dimension f2 of the adhesive 92 is the same or substantially the same as a dimension f3 of the first bonding end 51 of the second bonding electrode 5.

As shown in FIGS. 18, 19 and 20, the adhesive 92 includes, for example, a plurality of long strips of adhesive 92 arranged side by side and spaced apart; alternatively, the adhesive 92 has a network structure; alternatively, the adhesive 92 has a block structure. Thus, a bonding area between the electrode carrier plate 4 and the substrate 1 may increase, thereby achieving a rather stable connection between the two.

For example, an orthographic projection of the electrode carrier plate 4 on the substrate 1 does not overlap with an orthographic projection of the third portion 33 of the connecting lead 3 on the substrate 1, and an orthographic projection of the adhesive 92 on the substrate 1 does not overlap with the orthographic projection of the third portion 33 of the connecting lead 3 on the substrate 1. The adhesive 92 is disposed in an area, except for an area corresponding to the second bonding end 52 of the second bonding electrode 5 and the connecting via hole 41, on a side of the electrode carrier plate 4 proximate to the substrate 1.

The functions and effects of the adhesive 92 are the same as those mentioned above, and details are not repeated here.

In some embodiments, a plurality of connecting leads 3 are arranged side by side and spaced apart in the first direction X, and a plurality of second bonding electrodes 5 are arranged side by side and spaced apart in the first direction X. As shown in FIG. 21, the display panel 10 further includes a conductive adhesive D, which is provided on a side of the plurality of connecting leads 3 away from the non-display surface 1b of the substrate 1, and is configured to connect the plurality of second bonding electrodes 5 and the plurality of connecting leads 3. The conductive adhesive D extends in the first direction X. A third portion 33 of each connecting lead 3 located on the non-display surface 1b of the substrate 1 is electrically connected to a second bonding electrode 5. The conductive adhesive D covers at least portions of the plurality of connecting leads 3 connected to the plurality of second bonding electrodes 5.

For example, the conductive adhesive D is ACF.

In some examples, as shown in FIG. 21, the display panel 10 further includes an adhesive 92, and the adhesive 92 is located between the electrode carrier plate 4 and the substrate 1. In a direction perpendicular to the electrode carrier plate 4, a dimension f2 of the adhesive 92 is the same as a distance f4 between a surface of the conductive adhesive D away from the substrate 1 and the substrate 1.

For a distance and a proportional relationship between the second bonding electrode 5 and the third portion 33 of the connecting lead 3, reference may be made to the above description for the dimension relationship between the first bonding electrode 2 and the first portion 31 of the connecting lead 3, and details are not provided here.

It will be noted that, in some embodiments, the plurality of first bonding electrodes 2 have the same dimension in the first direction X. In some other embodiments, the plurality of first bonding electrodes 2 have different dimensions in the first direction X.

In some embodiments, the plurality of second bonding electrodes 5 have the same dimension in the first direction X. In some other embodiments, the plurality of second bonding electrodes 5 have different dimensions in the first direction X.

In some embodiments, the first portions 31 of the plurality of connecting leads 3 have the same dimension in the first direction X. In some other embodiments, the first portions 31 of the plurality of connecting leads 3 have different dimensions in the first direction X.

In some embodiments, the third portions 33 of the plurality of connecting leads 3 have the same dimension in the first direction X. In some other embodiments, the third portions 33 of the plurality of connecting leads 3 have different dimensions in the first direction X.

For example, as shown in FIGS. 6, 9 and 15, the light-emitting device layer 6 includes a plurality of light-emitting devices 61, a plurality of pixel driving chips 62 and a protective film 63. It can be understood that the pixel driving chip is used to provide driving signal to the light-emitting device 61. In some embodiments, the light-emitting device layer 6 may not have the pixel driving chips 62, but uses a thin film transistor provided in the driving circuit layer Q to provide the driving signal to the light-emitting device 61. The present disclosure does not limit here.

In some embodiments, as shown in FIGS. 2 and 3, the display panel 10 includes sub-pixels P of at least three colors. The sub-pixels of a plurality of colors include at least a sub-pixel of a first color, a sub-pixel of a second color and a sub-pixel of a third color. The first color, the second color and the third color are three primary colors (e.g., red, green and blue).

For example, each sub-pixel P includes at least one light-emitting device.

In some examples, as shown in FIGS. 6, 9, and 15, the protective film 63 includes a portion covering the plurality of light-emitting devices 61 and portions filling in gaps of the plurality of light-emitting devices 61. For example, the protective film 63 may be made of black silicone or black resin. The protective film 63 may protect the plurality of light-emitting devices 61 in the light-emitting device layer 6, thereby preventing the plurality of light-emitting devices 61 from being damaged in the process after the light-emitting devices 61 are formed.

For example, the light-emitting device 61 includes but is not limited to an organic light-emitting diode (OLED), a mini light-emitting diode (mini LED), and a micro light-emitting diode (micro LED).

In another aspect, a display device 100 is provided. The display device 100 includes the display panel 10 as described in any of the above embodiments.

The display device 100 may be any device that displays images whether in motion (such as a video) or fixed (such as a still image), and regardless of text or image. More specifically, it is expected that the embodiments may be implemented in or associated with a variety of electronic devices. The variety of electronic devices may include (but are not limit to), for example, mobile phones, wireless devices, personal digital assistants (PDAs), hand-held or portable computers, global positioning system (GPS) receivers/navigators, cameras, MPEG-4 Part 14 (MP4) video players, video cameras, game consoles, watches, clocks, calculators, TV monitors, flat-panel displays, computer monitors, car displays (e.g., odometer displays), navigators, cockpit controllers and/or displays, camera view displays (e.g., display of rear view camera in vehicles), electronic photos, electronic billboards or signs, projectors, architectural structures, packaging and aesthetic structures (e.g., displays for displaying an image of a piece of jewelry), etc.

For example, the above display device 100 may further include a frame and other electronic components. The display panel 10 may be, for example, disposed in the frame.

In yet another aspect, a tiled display device 1000 is provided. The tiled display device 1000 includes the display device 100 as described in any of the above embodiments.

As shown in FIGS. 23 and 24, the tiled display device 1000 includes a plurality of display devices 100 each as provided in the above embodiments.

For example, the plurality of display devices 100 in the tiled display device 1000 are arranged in an array.

For example, as shown in FIGS. 23 and 24, the display device 10 is in a shape of a rectangle.

In the display panel 10, a plurality of first bonding electrodes 2 are arranged side by side and spaced apart in the first direction X. Correspondingly, a plurality of connecting leads 3 are also arranged side by side and spaced apart in the first direction X. A direction parallel to a display surface of the display device 100 and perpendicular to the first direction X is called the second direction Y. The display device 100 includes a plurality of side faces. Hereinafter, side face(s) in the plurality of side faces of the display device 100 proximate to the first bonding area BB1 of the substrate 1 are referred to as selected side face(s) of the display device 100.

For example, as shown in FIG. 2, the substrate 1 includes a display area AA and two first bonding areas BB1 located on opposite sides of the display area AA. The display panel 10 includes two groups of first bonding electrodes, each group of first bonding electrodes include a plurality of first bonding electrodes, and the two groups of first bonding electrodes are respectively disposed proximate to the two first bonding areas BB1 of the substrate 1.

Further, as shown in FIG. 23, when a plurality of display devices 100 each including the display panel 10 shown in FIG. 2 are tiled, selected side faces of two adjacent display devices 100 are both provided in the first direction X. In this way, in multiple display devices 100 arranged in a row in the first direction X, there is substantially no tiling seam between two adjacent display devices 100 in the first direction X; and in multiple display devices 100 arranged in a column in the second direction Y, there is a tiling seam between two adjacent display devices 100. That is, a size of a tiling seam between two adjacent display devices in the multiple display devices 100 arranged in the row in the first direction X is smaller than a size of a tiling seam between two adjacent display devices 100 in the plurality of display devices 100 arranged in the column in the second direction Y

However, the size of the first bonding area BB1 in the second direction Y is very small. Therefore, when the tiled display device 1000 is actually viewed, the tiling seam between two adjacent display devices 100 is difficult to be found by naked eyes within a viewing distance. As a result, the display picture of the tiled display device 1000 is complete and may present a good display effect.

For example, as shown in FIG. 3, the display panel 10 includes a display area AA and a first bonding area BB1 located on a side of the display area AA. A plurality of first bonding electrodes 2 are provided proximate to the first bonding area BB1 of the substrate 1.

Further, as shown in FIG. 24, when a plurality of display devices 100 each including the display panel 10 shown in FIG. 3 are tiled, selected side faces of two adjacent display devices 100 are both provided in the first direction X. In this way, in multiple display devices 100 arranged in a row in the first direction X, there is substantially no tiling seam between two adjacent display devices 100 in the first direction X; and in multiple display devices 100 arranged in a column in the second direction Y, there is a tiling seam between two adjacent display devices 100. That is, a size of a tiling seam between two adjacent display devices in the multiple display devices 100 arranged in the row in the first direction X is smaller than a size of a tiling seam between two adjacent display devices 100 in the plurality of display devices 100 arranged in the column in the second direction Y

However, the size of the first bonding area BB1 in the second direction Y is very small. Therefore, when the tiled display device 1000 is actually viewed, the tiling seam between two adjacent display devices 100 is difficult to be found by naked eyes within a viewing distance. As a result, the display picture of the tiled display device 1000 is complete and may present a good display effect.

In yet another aspect, a method for manufacturing the display panel 10 is provided. As shown in FIG. 25, the method for manufacturing the display panel 10 includes following steps.

In S1, a substrate 1 is provided.

The substrate 1 includes a display surface 1a and a non-display surface 1b that are opposite, and a plurality of side faces 1c connected to the display surface 1a and the non-display surface 1b. At least one side face 1c in the plurality of side faces 1c is a selected side face 1cc. The display surface 1a includes first bonding area(s) BB1, and the non-display surface 1b includes second bonding area(s) BB2. The first bonding area BB1 and the second bonding area BB2 are both proximate to a selected side face 1cc and are disposed oppositely.

In S2, a plurality of first bonding electrodes 2 side by side and spaced apart are formed.

As shown in FIGS. 2 and 3, the plurality of first bonding electrodes 2 are provided in the first bonding area BB1.

In S3, a plurality of connecting leads 3 side by side and spaced apart are formed.

As shown in FIGS. 6, 9, 15 and 21, each connecting lead 3 includes a first portion 31 located in the first bonding area BB1, a second portion 32 located on the selected side face 1cc, and a third portion 33 located in the second bonding area BB2. The first portion 31 of each connecting lead 3 is connected to a first bonding electrode 2.

In S4, an electrode carrier plate 4 is provided, and as shown in FIGS. 10 to 14 and 16 to 20, a plurality of second bonding electrodes 5 side by side and spaced apart are formed on the electrode carrier plate 4.

In S5, the electrode carrier plate 4 provided with the plurality of second bonding electrodes 5 thereon is provided on a side of the non-display surface 1b of the substrate 1, and each second bonding electrode 5 is connected with a third portion 33 of a connecting lead 3.

As shown in FIGS. 6, 9, 15 and 21, the first bonding area BB1 and the second bonding area BB2 are provided oppositely, and the first bonding area BB1 and the second bonding area BB2 both extend in the first direction X.

In step S3, for example, an entire metal layer is first formed on the selected side face 1cc of the substrate 1 through a three-dimensional sputtering coating process; then, the metal layer is trimmed by laser etching, and the metal layer is patterned to form the plurality of connecting leads 3, so that the wiring on the front surface of the substrate 1 (e.g., the driving circuit layer Q) is routed to the back surface through the selected side face 1cc.

In a case where a length d2 of the connecting lead 3 at the back surface is greater than a length d1 thereof at the front surface, the line at the back surface that needs to be laser etched (i.e., the third portion 33 of each of the plurality of connecting leads 3 located on the non-display surface 1b of the substrate 1) is longer than the first portion 31 of each of the plurality of connecting leads 3 located on the display surface 1a of the substrate 1. That is, during etching the back surface, the laser will be irradiated into the front display area AA. As shown in FIG. 1, laser is irradiated to the substrate 1 in directions of Laser shown in figure. The laser emitted from the back surface of the substrate 1 will be irradiated into the display area AA, and the residual energy will cause damage to film layer(s) in the display area AA and even affect characteristics of the light-emitting devices, resulting in quality problems such as local corrosion, NG reliability, and failure to light up in products.

The above manufacturing process such as sputtering coating and laser etching are only described as examples and are not intended to limit the actual production process.

By adding step S4, the plurality of second bonding electrodes 5 are added. As shown in FIGS. 4 and 5, the plurality of second bonding electrodes 5 replace parts of the third portions 33 of the connecting leads 3 shown in FIG. 1 extending to an area corresponding to the display area AA, and the plurality of second bonding electrodes 5 are separately formed on the electrode carrier plate. In step S5, the plurality of second bonding electrodes 5 and the electrode carrier plate 4 are integrated as a whole to be connected to the plurality of connecting leads 3 and to be fixed on the non-display surface 1b of the substrate 1. There is no overlap between an area of the display surface 1a of the substrate 1 corresponding to an orthographic projection of the third portion 33 of the connecting lead 3 on the substrate 1 and the display area AA. It can be understood that with such a design, when the third portion 33 of the connecting lead 3 is formed by laser etching, it may effectively prevent the laser from passing through the substrate 1 and then being irradiated into the film structure at the front of the substrate 1.

In some embodiments, the plurality of second bonding electrodes 5 provided on the electrode carrier plate 4 are formed by, for example, printing.

For example, the second bonding electrodes 5 are formed by 3D printing, screen transfer printing, pad printing/transfer printing, or stencil printing.

It can be understood that when the second bonding electrodes 5 are formed by, for example, printing, since the forming process of the second bonding electrodes 5 does not use laser, the second bonding electrodes 5 may be directly formed on the non-display surface 1b of the substrate 1 without using an electrode carrier plate 4, and may not affect the film layer structure within the display area AA.

In some other embodiments, the second bonding electrodes 5 are formed by, for example, sputtering coating and laser etching. For example, a metal film is first formed on the electrode carrier plate 4 by sputtering coating, and then the metal film is etched by laser to form conductive patterns, which are the plurality of second bonding electrodes 5.

The foregoing descriptions are merely specific implementations of the present disclosure, but the protection scope of the present disclosure is not limited thereto. Changes or replacements that any person skilled in the art could conceive of within the technical scope of the present disclosure shall be included in the protection scope of the present disclosure. Therefore, the protection scope of the present disclosure shall be subject to the protection scope of the claims.

## Claims

1. A display panel, comprising:
a substrate including a display surface and a non-display surface that are opposite, and a plurality of side faces connected to the display surface and the non-display surface, wherein at least one side face is a selected side face; the display surface includes a first bonding area, the non-display surface includes a second bonding area, and the first bonding area and the second bonding area are both proximate to the selected side face and disposed oppositely;
a plurality of first bonding electrodes disposed side by side and at intervals in the first bonding area;
a plurality of connecting leads disposed side by side and at intervals, wherein each connecting lead includes a first portion located in the first bonding area, a second portion located on the selected side face and a third portion located in the second bonding area; the first portion of each connecting lead is electrically connected to a first bonding electrode; and
an electrode carrier plate disposed on the non-display surface, wherein a plurality of second bonding electrodes arranged side by side and at intervals are provided on a surface of the electrode carrier plate away from the substrate, and each second bonding electrode is electrically connected to a third portion of a connecting lead.

2. The display panel according to claim 1, wherein the display panel further comprises:
a plurality of connection pads located on a side of the plurality of second bonding electrodes away from the substrate, wherein the plurality of connection pads are arranged side by side and at intervals; and each connection pad is connected to a second bonding electrode and a third portion of a connecting lead.

3. The display panel according to claim 2, wherein a material of the connection pad includes metal or conductive adhesive.

4. The display panel according to claim 2 or 3, wherein a shape of an orthographic projection of the connection pad on the substrate includes a circle, an ellipse, a triangle, a star, a square, a heart or a trapezoid.

5. The display panel according to claim 1, wherein the electrode carrier plate is provided therein with a plurality of connecting via holes arranged side by side and at intervals;
each second bonding electrode includes a first bonding end and a second bonding end; the first bonding end of the second bonding electrode is located on a side of the electrode carrier plate away from the substrate; and the second bonding end of the second bonding electrode passes through a connecting via hole to be electrically connected to the third portion of the connecting lead.

6. The display panel according to claim 5, wherein the second bonding end is located on a side of the third portion of the connecting lead connected to the second bonding end away from the substrate; and the display panel further comprises:
a binder disposed in the connecting via hole and configured to connect the second bonding end and the third portion of the connecting lead.

7. The display panel according to claim 5 or 6, wherein the display panel further comprises:
an adhesive disposed on a side of the second bonding end away from the selected side face and configured to bond the electrode carrier plate and the substrate, wherein a surface of the adhesive is bonded to a surface of the electrode carrier plate proximate to the substrate, and another surface of the adhesive faces the substrate; wherein
the second bonding end is located on a side of the third portion of the connecting lead connected to the second bonding end away from the substrate, and the adhesive is located between the electrode carrier plate and the substrate; in a direction perpendicular to the electrode carrier plate, a dimension of the adhesive is same as a dimension of the third portion of the connecting lead.

8. The display panel according to claim 7, wherein the adhesive is an insulating adhesive.

9. The display panel according to claim 5, wherein the plurality of connecting leads are arranged side by side and at intervals in a first direction, and the plurality of second bonding electrodes are arranged side by side and at intervals in the first direction;
the display panel further comprises:
a conductive adhesive disposed on a side of the plurality of connecting leads away from the non-display surface and configured to connect the second bonding electrode and the connecting lead; the conductive adhesive extending in the first direction, wherein
the conductive adhesive covers at least portions of the connecting leads connected to the plurality of second bonding electrodes.

10. The display panel according to any one of claims 1 to 9, wherein a material of the electrode carrier plate includes an insulated material.

11. The display panel according to claim 10, wherein the material of the electrode carrier plate includes glass or a polyimide film.

12. The display panel according to any one of claims 1 to 11, wherein
a material of the first bonding electrodes includes metal; and
materials of the connecting leads and the second bonding electrodes include metal or conductive metal colloid.

13. The display panel according to claim 12, wherein
the material of the first bonding electrodes includes at least one of copper, titanium, aluminum, molybdenum or nickel alloy; and
the materials of the connecting leads and the second bonding electrodes include at least one of copper, titanium, aluminum, molybdenum, nickel alloy, or conductive silver adhesive.

14. The display panel according to any one of claims 1 to 4 and 10 to 13, wherein the second bonding area extends in a first direction, the third portion of each connecting lead extends in a second direction, and the first direction intersects the second direction;
a dimension of a connection pad in the first direction is greater than one third of a dimension of a third portion of a connecting lead connected to the connection pad in the first direction.

15. The display panel according to claim 13, wherein a sum of a dimension of the third portion of the connecting lead connected to the second bonding electrode in the first direction and a distance between third portions of two adjacent connecting leads in the first direction is greater than the dimension of the connection pad in the first direction.

16. The display panel according to any one of claims 1 to 4, 10, and 11 to 15, wherein
a dimension of a connection pad in a direction perpendicular to the selected side face is less than or equal to a distance between an edge of an orthographic projection of the second bonding electrode connected to the connection pad on the substrate away from the selected side face and the selected side face.

17. The display panel according to any one of claims 1 to 16, wherein the display panel further comprises:
a flexible circuit board disposed on a side of the plurality of second bonding electrodes away from the substrate, wherein
each second bonding electrode extends in a second direction; a first bonding end is configured to be electrically connected to the flexible circuit board, and a second bonding end is configured to be electrically connected to the third portion of the connecting lead.

18. The display panel according to any one of claims 1 to 17, wherein portions of a second bonding end and the third portion of the connecting lead that are connected have an overlap;
a sum of a dimension of the third portion of the connecting lead in a direction perpendicular to the selected side face and a dimension of the second bonding electrode in the direction perpendicular to the selected side face is equal to,
a sum of a distance between an edge of an orthographic projection of the second bonding electrode on the substrate away from the selected side face and the selected side face and a dimension of a portion of the second bonding end overlapped with the third portion of the connecting lead in the direction perpendicular to the selected side face.

19. The display panel according to any one of claims 1 to 18, wherein a dimension of the third portion of the connecting lead in a direction perpendicular to the selected side face is less than or equal to a distance between an edge of an orthographic projection of the first bonding electrode on the substrate away from the selected side face and the selected side face.

20. The display panel according to any one of claims 1 to 19, wherein a dimension of the first portion of the connecting lead connected to the first bonding electrode in a direction perpendicular to an extending direction of the first portion of the connecting lead is greater than or equal to thirty percent of a dimension of the first bonding electrode in a direction perpendicular to an extending direction of the first bonding electrode.

21. The display panel according to claim 20, wherein a difference between a sum of the dimension of the first bonding electrode in the direction perpendicular to the extending direction of the first bonding electrode and a distance between two adjacent first bonding electrodes in the direction perpendicular to the extending direction of the first bonding electrodes and a distance between first portions of two adjacent connecting leads in a direction perpendicular to an extending direction of the first portions of the two connecting leads is greater than or equal to the dimension of the first portion of the connecting lead connected to the first bonding electrode in the direction perpendicular to the extending direction of the first portion of the connecting lead.

22. A display device, comprising the display panel according to any one of claims 1 to 21.

23. A tiled display device, comprising the display device according to claim 22.

24. A method for manufacturing a display panel, comprising:
providing a substrate, wherein the substrate includes a display surface and a non-display surface that are opposite, and a plurality of side faces connected to the display surface and the non-display surface; at least one side face in the plurality of side faces is a selected side face; the display surface includes a first bonding area, the non-display surface includes a second bonding area, and the first bonding area and the second bonding area are both proximate to the selected side face and disposed oppositely;
forming a plurality of first bonding electrodes arranged side by side and at intervals on the display surface of the substrate; the plurality of first bonding electrodes being disposed in the first bonding area;
forming a plurality of connecting leads arranged side by side and at intervals, wherein each connecting lead includes a first portion located in the first bonding area, a second portion located on the selected side face and a third portion located in the second bonding area; the first portion of each connecting lead is electrically connected to a first bonding electrode;
providing an electrode carrier plate and forming a plurality of second bonding electrodes arranged side by side and at intervals on the electrode carrier plate; and
providing the electrode carrier plate provided with the plurality of second bonding electrodes thereon on a side of the non-display surface, and connecting each second bonding electrode to a third portion of a connecting lead.
